Europäisches Patentamt

European Patent Office

Office européen des brevets

(19)

(11) **EP 1 422 317 A1**

(12) **EUROPEAN PATENT APPLICATION**
published in accordance with Art. 158(3) EPC

(43) Date of publication:
    **26.05.2004 Bulletin 2004/22**

(51) Int Cl.[7]: **C23C 16/455**, H01L 21/285

(21) Application number: **02751825.7**

(22) Date of filing: **01.08.2002**

(86) International application number:
    **PCT/JP2002/007856**

(87) International publication number:
    **WO 2003/012165 (13.02.2003 Gazette 2003/07)**

(84) Designated Contracting States:
    **AT BE BG CH CY CZ DE DK EE ES FI FR GB GR
    IE IT LI LU MC NL PT SE SK TR**

(30) Priority: **01.08.2001 JP 2001233947
              12.03.2002 JP 2002067490
              21.06.2002 JP 2002182010**

(71) Applicant: **TOKYO ELECTRON LIMITED
    Minato-ku, Tokyo 107-8481 (JP)**

(72) Inventors:
    • **KASAI, Shigeru, c/o Tokyo Electron AT Limited
      Nirasaki-shi, Yamanashi 407-0192 (JP)**
    • **YAMAMOTO, Norihiko,
      c/o Tokyo Electron AT Limited
      Nirasaki-shi, Yamanashi 407-0192 (JP)**
    • **TANAKA, Masayuki,
      c/o Tokyo Electron AT Limited
      Nirasaki-shi, Yamanashi 407-0192 (JP)**

(74) Representative: **Liesegang, Eva
    Forrester & Boehmert,
    Pettenkoferstrasse 20-22
    80336 München (DE)**

(54) **GAS TREATING DEVICE AND GAS TREATING METHOD**

(57)     A gas processing apparatus 1 includes a processing container 2 for applying a processing to a wafer W while using a processing gas, a mount table 5 arranged in the processing container 2 to mount the wafer W, a shower head 22 arranged corresponding to the wafer W on the mount table 5 to discharge the processing gas into the processing container 2 and exhausting means 132 for exhausting the interior of the processing container 2. The shower head 22 has first gas discharging holes 46 arranged corresponding to the wafer W mounted on the mount table 5 and second gas discharging holes 47 arranged around the first gas discharging holes 46 independently to discharge the processing gas to the peripheral part of the wafer W. Thus, with a uniform gas supply to a substrate, it is possible to perform a uniform gas processing.

FIG. 2

## Description

### TECHNICAL FIELD

The present invention relates to a gas processing apparatus and a gas processing method for performing a gas processing of a substrate to be processed by use of a processing gas.

### BACKGROUND OF ART

In the semiconductor manufacturing process, metal, for example, W (tungsten), WSi (tungsten silicide), Ti (titanium), TiN (titanium nitride), TiSi (titanium silicide), etc. or metallic compound thereof is deposited to form a film in order to fill up contact holes formed on a semiconductor wafer as an object to be processed (referred "wafer" hereinafter) or wiring holes for connecting wires to each other.

As the film deposition for these elements, physical vapor deposition (PVD) technique has been employed conventionally. Recently, however, both of miniaturization and high integration of a device have been particularly required and therefore, its design rule becomes severe in particular. Correspondingly, as both device's line-width and diameter of holes become smaller with the progress of high aspect ratio, a "PVD" film has been getting incapacitated. Therefore, it has been recently carried out to form a film of such a metal or metal compounds by chemical vapor deposition (CVD) technique promising an ability of forming a film of better quality.

For example, by use of $WF_6$ (tungsten hexafluoride) gas as the processing gas and $H_2$-gas as the reduction gas, a W-film is produced due to a reaction on a wafer represented by the formula of "$WF_6 + H_2 \rightarrow W + 6HF$". The CVD film deposition process like this is carried out by mounting a wafer on a mount table in a processing container and further supplying the container with $WF_6$-gas and $H_2$-gas discharged from a shower head as being a gas discharging mechanism arranged in a position opposing the wafer while exhausting the interior of the processing container, thereby forming a designated "processing-gas" atmosphere in the processing container.

Under the process like this, however, as a reduction gas having a high diffusion velocity, e.g. $H_2$-gas, quickly diffuses in the processing container throughout and is discharged therefrom, the concentration of the reduction gas is easy to drop around the peripheral part of a wafer. Particularly, since the film deposition apparatus has been large-sized corresponding to a recent large-sized wafer from 200 mm to 300 mm in size, the above reduction in the concentration of the reduction gas in the periphery of the wafer becomes remarkable to cause a film deposition rate to be lowered in the same area. Consequently, the uniformity in film thickness is lowered remarkably.

Meanwhile, when forming a W-film on $SiO_2$ or Si, it is performed in advance of the deposition of W-film to cover the $SiO_2$ or Si with thin and uniform Ti-film, TiN-film or their lamination film as the barrier layer in view of improvement in adhesive property between a W-film and the $SiO_2$ or Si, restriction of a reaction of W with Si, etc. In connection, when filling in recesses or the like, hydrogen gas exhibiting reduction property less than that of silane gas ($Si_nH_{2m+n}$, $SiH_nCl_{4-n}$) is mainly used in order to make its embedding property excellent. Then, there is a possibility that the "under" barrier layer is attacked by non-reacted $WF_6$-gas, so that the barrier layer reacts with fluorine to expand its volume thereby producing a projecting defect called "volcano" and further, there is an occasion that voids occur in holes to be embedded. In order to prevent the occurrence of such defects, it is attempted to firstly form a nucleate W-film (nucleation film) by a minimal thickness in the order from 30 to 50 nm with by the use of silane gas having more intensive reduction power in place of hydrogen gas and subsequently, to form a main W-film with the nucleation film as the starting point by the use of $H_2$-gas and $WF_6$-gas. However, in spite of the adoption of such a method, the step coverage of a nucleation film is deteriorated due to contamination etc. on the surface of a barrier layer as the under layer, so that the fill-in property of the main W-film gets worse. This tendency becomes remarkable with the progress of miniaturization in semiconductor devices.

In order to solve such a problem, it is also attempted, in advance of the formation of the nucleation film, to perform an initiation process to allow the under barrier layer to absorb $SiH_X$ (X<4) with the supply of only silane gas for a predetermined period and subsequently, to make a growth of the nucleation film with the so-absorbed barrier layer as the starting point. However, this measure is believed to be insufficient.

Therefore, we and applicant previously proposed a technique to form an initial W-film on the surface of a substrate to be processed (Japanese Patent Application No. 2001-246089). According to the technique, there are repeatedly performed a reduction-gas supply process of supplying the reduction gas and a W-gas supply process of supplying a W-content gas with the interposition of a purging process of evacuating while supplying an inert gas between the above processes. With this technique, it is possible to form a uniform nucleation film in even a minute hole, with high step coverage, whereby the above problem can be solved.

Nevertheless, if the above technique is applied to a normal W-film deposition apparatus, then $WF_6$-gas reacts to silane gas in a shower head as a gas discharging mechanism, so that a W-film is formed in the shower head, thereby decreasing the reproducibility among the surfaces of wafers. In order to avoid an occurrence of such a problem, it is necessary to lower a temperature of a gas discharging part of the shower head less than 30°C. However, since the shower head is generally cooled down from its lateral surface, it is difficult to attain the temperature of a central part of the shower head less than 30° C by means of generally cooling water. In the present circumstances where the shower head is also large-sized because of large-sized wafers, the requirement of attaining the temperature of the central part of the shower head less than 30° C would require an ultra cold chiller to cause a great increase in the installation cost of a system due to countermeasures of dew condensation etc.

In the CVD film deposition apparatus of this kind, meanwhile, if forming a W-film on a substrate having an exposed TiN-film, then a compound "TiN" is etched by fluorine during the film depositing operation, so that reaction by-product materials, such as titanium fluoride (TiF$_X$), stick to the shower head and the inner wall of the chamber and thereafter, the by-product materials are peeled off to be the origin of particles. Therefore, after completing a designated film deposition, it is carried out to introduce ClF$_3$-gas (as a cleaning gas) into a chamber through a shower head thereby cleaning the apparatus. Regarding this cleaning, since the cleaning efficiency is increased with elevated temperature, there is performed a "flashing" process to introduce ClF$_3$-gas into the chamber while heating the shower head at predetermined intervals by a heater embedded in the shower head.

However, due to the shower head being large-sized for large wafers that requires for the heater to have a high-power output, heat from the shower head to a container lid is also heat transferred, so that the heater is required to have more power to compensate such a dissipative heat. The requirement makes it difficult to elevate the temperature of the shower head up to a predetermined temperature.

Additionally, with an apparatus being large-sized, if heating the shower head by the heater, then the shower head has a thermal expansion of the order of 1 mm, so that a problem of heat distortion about the shower head arises.

Under such a situation, an object of the present invention is to provide a gas processing apparatus and a gas processing method by which it is possible to avoid defects about a gas discharging mechanism, the defects being accompanied with the apparatus being large-sized.

More in detail, an object of the invention is to provide a gas processing apparatus and a gas processing method that can perform a uniform gas processing by supplying a substrate with gas uniformly. Additionally, an object of the invention is to provide a gas processing apparatus that allows a gas discharging mechanism to be heated with high efficiency. Further, an object of the invention is to provide a gas processing apparatus that can reduce an influence of thermal expansion when the gas discharging mechanism is heated. Still further, in case of an apparatus that alternately supplies two processing gases required to keep a temperature of the gas discharging mechanism low, an object of the invention is to provide the gas processing apparatus that can cool the whole gas discharging mechanism to a desired temperature without using any special installation, such as ultra cold chiller, despite that the gas discharging mechanism is large-sized.

Further, in case of supplying two processing gases alternately to form a film, an object of the invention is to provide a gas processing apparatus and a gas processing method that can prevent formation of an unnecessary film in the gas discharging mechanism without cooling specially.

DISCLOSURE OF THE INVENTION

In order to solve the above-mentioned problems, according to the first aspect of the present invention, there is provided a gas processing apparatus comprising: a processing container for accommodating a substrate to be processed; a mount table arranged in the processing container to mount the substrate; a processing-gas discharging mechanism arranged in a position opposing the substrate to be processed mounted on the mount table to discharge a processing gas into the processing container; and exhausting means for exhausting an interior of the processing container, wherein the processing-gas discharging mechanism includes: a first gas discharging part provided corresponding to the substrate to be processed mounted in the mount table and a second gas discharging part arranged around the first gas discharging part independently to discharge the processing gas into the periphery of the substrate to be processed mounted on the mount table.

In the second aspect of the present invention, there is provided a gas processing apparatus for applying a gas processing to a substrate to be processed while using a first processing gas of a relatively high diffusion velocity and a second processing gas of a relatively low diffusion velocity, the gas processing apparatus comprising: a processing container for accommodating a substrate to be processed; a mount table arranged in the processing container to mount the substrate to be processed thereon; a processing-gas discharging mechanism arranged in a position opposing the substrate to be processed mounted on the mount table to discharge a gas containing the first processing gas and the second processing gas into the processing container; and exhausting means for exhausting an interior of the processing container, wherein the processing-gas discharging mechanism includes: a first gas discharging part provided corresponding to the substrate to be processed mounted in the mount table to discharge the gas containing the first processing gas and the second processing gas and a second gas discharging part arranged around the first gas discharging part independently, to discharge the first processing gas into the periphery of the substrate to be processed mounted on the mount table.

In the third aspect of the present invention, there is provided a gas processing apparatus comprising: a processing container for accommodating a substrate to be processed; a mount table arranged in the processing container to mount the substrate to be processed thereon; a processing-gas discharging mechanism arranged in a position opposing the substrate to be processed mounted on the mount table to discharge a processing gas containing $H_2$-gas and $WF_6$-gas into the processing container; and exhausting means for exhausting an interior of the processing container, wherein the processing-gas discharging mechanism includes: a first gas discharging part provided corresponding to the substrate to be processed mounted in the mount table to discharge the processing gas containing $H_2$-gas and $WF_6$-gas and a second gas discharging part arranged around the first gas discharging part independently, to discharge $H_2$-gas into the periphery of the substrate to be mounted on the mount table.

In the fourth aspect of the present invention, there is provided a gas processing method for applying a gas processing to a substrate to be processed in a processing container while supplying a processing gas to the substrate, the gas processing method comprising the steps of: discharging the processing gas through a first gas discharging part provided so as to oppose the substrate to be processed; and discharging the processing gas to the periphery of the substrate to be processed through a second gas discharging part provided around the first gas discharging part independently, thereby performing the gas processing.

In the fifth aspect of the present invention, there is provided a gas processing method for applying a gas processing to a substrate to be processed while supplying the substrate in a processing container with a first processing gas of a relatively high diffusion velocity and a second processing gas of a relatively low diffusion velocity, the gas processing method comprising the steps of: discharging a gas containing the first processing gas and the second processing gas from a first gas discharging part that is arranged so as to oppose the substrate to be processed; and further discharging the first processing gas from a second gas discharging part that is arranged around the first gas discharging part independently, thereby performing the gas processing.

In the sixth aspect of the present invention, there is provided a gas processing method for applying a gas processing to form a W-film on a substrate to be processed while supplying the substrate to be processed in a processing container with a processing gas containing $H_2$-gas and $WF_6$-gas, the gas processing method comprising the steps of: discharging a processing gas containing $H_2$-gas and $WF_6$-gas from a first gas discharging part that is arranged so as to oppose the substrate to be processed, and discharging $H_2$-gas from a second gas discharging part that is arranged around the first gas discharging part independently, thereby forming the W-film on the substrate to be processed.

According to the first aspect and the fourth aspect of the present invention, by discharging the processing gas through the first gas discharging part and further discharging the processing gas from the second gas discharging part, which is arranged around the first gas discharging part independently, into the periphery of the substrate to be processed, it is possible to prevent the concentration of the processing gas from being lowered in the periphery of the substrate to be processed, whereby an in-plane uniform gas processing can be applied to the substrate to be processed.

Again, according to the second aspect and the fifth aspect of the present invention, by discharging a mixing gas of the first and second processing gases through the first gas discharging part and further discharging the first processing gas from the second gas discharging part, which is arranged around the first gas discharging part independently, into the periphery of the substrate to be processed, it is possible to prevent the concentration of the first processing gas, which is easy to diffuse due to its relatively high diffusion velocity, from being lowered in the periphery of the substrate to be processed, whereby the in-plane uniform gas processing can be applied to the substrate to be processed.

Further, according to the third aspect and the sixth aspect of the present invention, by discharging the processing gas containing $H_2$-gas and $WF_6$-gas through the first gas discharging part and further discharging $H_2$-gas from the second gas discharging part, which is arranged around the first gas discharging part independently, into the periphery of the substrate to be processed, it is possible to prevent the concentration of $H_2$-gas, which is easy to diffuse due to its relatively high diffusion velocity, from being lowered in the periphery of the substrate to be processed, whereby the in-plane uniform gas processing can be applied to the substrate to be processed.

In common with the above gas processing apparatuses, the gas discharging mechanism may include a gas discharging plate having the first gas discharging part and the second gas discharging part, while each of the first gas discharging part and the second discharging part may have a plurality of gas discharging holes formed in the gas discharging plate. Then, the gas discharging mechanism may be constructed to have a coolant passage. Further, it is preferable that the coolant passage is arranged is an area of the gas discharging plate where the gas discharging holes are formed. The coolant passage is formed so as to correspond to the shape of a gas discharging plate's part interposed among the plural gas discharging holes in the gas discharging plate's area where the gas discharging holes are formed. For example, the coolant passage is formed concentrically. Further, the gas discharging mechanism may have a heater.

Again, it is preferable that the plural gas discharging holes included in the second gas discharging part are arranged outside the periphery of the substrate to be processed on the mount table. Further, it is also preferable that the plural gas discharging holes included in the second gas discharging part are arranged perpendicularly to the substrate to be processed on the mount table. With the arrangement mentioned above, it is possible to prevent the concentration of the first processing gas from being lowered in the periphery of the substrate to be processed. In the second gas discharging part as above, the plural gas discharging holes may be arranged in the periphery of the first gas discharging part, in one or more lines. Alternatively, the plural gas discharging holes may form a first line and a second line, both of which are concentric to each other, in the periphery of the first gas discharging part and the gas discharging holes forming the first line and the gas discharging holes forming the second line may be arranged alternately.

Further, it is preferable that the above gas processing apparatus comprises a coolant passage arranged in the processing-gas discharging mechanism; a coolant flow piping arranged both in front of the coolant passage and in the rear; a bypass piping connected, both in front of the processing-gas discharging mechanism and in the rear, to the coolant flow piping while bypassing the processing-gas discharging mechanism; a pressure relief valve arranged on the downstream side of the coolant passage in the coolant flow piping; a valves defining a flowing pathway of the coolant; control means for controlling the valves; and a heater for heating the processing-gas discharging mechanism, wherein when cooling the processing-gas discharging mechanism, the control means controls the valves so as to allow the coolant to flow into the coolant passage, when heating the processing-gas discharging mechanism, the control means operates the heater and further controls the valves so as to stop the inflow of the coolant into the coolant passage and allow the coolant to flow into the bypass piping, and when lowering a temperature of the processing-gas discharging mechanism in its elevated condition in temperature, the control means controls the valves so as to allow the coolant to flow into both of the coolant passage and the bypass piping. Consequently, it is possible to attain rapid ascent and descent in temperature of the gas discharging mechanism.

Moreover, in any one of the above-mentioned gas processing apparatuses, it is preferable that the exhausting means carries out exhaust from the peripheral side of the substrate to be processed on the mount table. In this case, preferably, the gas processing apparatus further comprises an annular baffle plate having a plurality of exhaust holes, wherein the exhausting means exhausts the interior of the processing container through the exhaust holes. Furthermore, in any one of the above-mentioned gas processing methods, it is preferable to carry out exhaust from the peripheral side of the substrate to be processed, at the gas processing.

In the seventh aspect of the present invention, there is provided a gas processing apparatus comprising: a processing container for accommodating a substrate to be processed; a mount table arranged in the processing container to mount the substrate to be processed thereon; a processing-gas discharging mechanism arranged in a position opposing the substrate to be processed mounted on the mount table to discharge a processing gas into the processing container; and exhausting means for exhausting an interior of the processing container, wherein the processing-gas discharging mechanism includes a gas discharging part having a discharging hole for discharging the processing gas; a base part supporting the gas discharging part; a heater provided in the gas discharging part; and a gap layer defined between the gas discharging part and the base part.

With the above-mentioned constitution, since the gap layer formed between the gas discharging part and the base part functions as a heat insulating layer to suppress heat dispersion from the heater of the gas discharging part, it is possible to uniformly heat the gas discharging part with high efficiency. Then, it is likely that the gas leaks out from the gas discharging mechanism through the gap layer. In order to prevent such a leakage, however, a seal ring etc. may be interposed between the gas discharging part and the base part.

In the eighth aspect of the present invention, there is provided a gas processing apparatus comprising: a processing container for accommodating a substrate to be processed; a mount table arranged in the processing container to mount the substrate to be processed thereon; a processing-gas discharging mechanism arranged in a position opposing the substrate to be processed mounted on the mount table to discharge a processing gas into the processing container; and exhausting means for exhausting an interior of the processing container, wherein the processing-gas discharging mechanism includes a gas discharging part having a discharging hole for discharging the processing gas; a base part supporting the gas discharging part; a heater provided in the gas discharging part; and a fastening mechanism for fastening the gas discharging part to the base part so as to allow a relative displacement therebetween.

In this way, as the gas discharging part is fastened to the base part so as to allow a relative displacement therebetween, even if the gas discharging part is heated by the heater and expanded thermally, there is produced almost no strain in the gas discharging part and also in the base part due to the relative displacement between the gas discharging part and the base part, whereby it is possible to reduce the influence of thermal expansion on the gas discharging part.

In the ninth aspect of the present invention, there is provided a gas processing apparatus comprising: a processing container for accommodating a substrate to be processed; a mount table arranged in the processing container to mount the substrate to be processed thereon; first processing-gas supplying means for supplying a first processing gas into the processing container; second processing-gas supplying means for supplying a second processing gas into the processing container; a processing-gas discharging mechanism arranged in a position opposing the substrate to be processed mounted on the mount table to discharge the first processing gas and the second processing gas supplied from the first and second processing-gas supplying means respectively, into the processing container; and exhausting means for exhausting an interior of the processing container, the gas processing apparatus supplying the first processing gas and the second processing gas alternately to react these gases on the substrate to be processed thereby forming a designated film thereon, wherein the processing-gas discharging mechanism includes a gas discharging plate having a plurality of gas discharging holes for discharging the first and second processing gases and a coolant passage, and the coolant passage is arranged in a gas discharging plate's area where the gas discharging holes are formed.

According to the constitution mentioned above, in the apparatus to supply the first processing gas and the second processing gas, which are required to keep the temperature of the gas discharging part of the gas discharging mechanism low, the coolant passage is arranged in the gas discharging plate's area where the gas discharging holes are formed. Therefore, even if the gas discharging mechanism is large-sized with the large-sized substrate to be processed, it becomes possible to effectively cool the gas discharging part to a desired temperature without using any special installation, such as ultra cold chiller and with a normal coolant, such as cooling water.

In this case, the coolant passage is formed so as to correspond to the shape of a gas discharging plate's part interposed among the plural gas discharging holes in the gas discharging plate's area where the gas discharging holes are formed. For instance, the coolant passage is formed concentrically, for example, as a groove. The processing-gas discharging mechanism may be provided with a heater.

In the gas processing apparatus of the ninth aspect, it is preferable that the apparatus further comprises: a coolant flow piping arranged both in front of the coolant passage and in the rear; a bypass piping connected, both in front of the processing-gas discharging mechanism and in the rear, to the coolant flow piping while bypassing the processing-gas discharging mechanism; a pressure relief valve arranged on the downstream side of the coolant passage in the coolant flow piping; a group of valves defining a flowing pathway of the coolant; control means for controlling the group of valves; and a heater for heating the processing-gas discharging mechanism, wherein when cooling the processing-gas discharging mechanism, the control means controls the group of valves so as to allow the coolant to flow into the coolant passage, when heating the processing-gas discharging mechanism, the control means operates the heater and further controls the group of valves so as to stop the inflow of the coolant into the coolant passage and allow the coolant to flow into the bypass piping, and when lowering a temperature of the processing-gas discharging mechanism in its elevated condition in temperature, the control means controls the group of valves so as to allow the coolant to flow into both of the coolant passage and the bypass piping.

In the tenth aspect of the present invention, there is provided a gas processing method for alternately supplying a first processing gas and a second processing gas to a substrate to be processed in a processing container with through a gas discharging member to allow these gases to react on the substrate to be processed thereby forming a designated film thereon, the gas processing method comprising the step of supplying the first processing gas and the second processing gas into the processing container through gas supply pathways separated from each other in the gas discharging member.

In the eleventh aspect of the present invention, there is provided a gas processing apparatus comprising: a processing container for accommodating a substrate to be processed; a mount table arranged in the processing container to mount the substrate to be processed thereon; first processing-gas supplying means for supplying a first processing gas into the processing container; second processing-gas supplying means for supplying a second processing gas into the processing container; a processing-gas discharging mechanism arranged in a position opposing the substrate to be processed mounted on the mount table to discharge the first processing gas and the second processing gas supplied from the first and second processing-gas supplying means respectively, into the processing container; and exhausting means for exhausting an interior of the processing container, the gas processing apparatus supplying the first processing gas and the second processing gas alternately to react these gases on the substrate to be processed thereby forming a designated film thereon, wherein the processing-gas discharging mechanism includes a first gas supply pathway and a second gas supply pathway separated from each other, and the first processing gas and the second processing gas are discharged through the first gas supply pathway and the second gas supply route, respectively and individually.

According to the tenth and the eleventh aspects, when alternately supplying the first processing gas and the second processing gas in order to form a film, the processing container is supplied with the first processing gas and the second processing gas through the gas supply pathways separated from each other in the gas discharging member. Therefore, in the gas discharging member, the first processing gas does not come into contact with the second processing gas, so that it becomes possible to prevent deposition of undesired film in the gas discharging member without any special cooling.

In the tenth aspect, it is preferable to interpose a purging step of purging the interior of the processing container between the supply of the first processing gas and the supply of the second processing gas.

In the eleventh aspect, it is preferable that the gas processing apparatus further comprises purge means for purging the interior of the processing container between the supply of the first processing gas and the supply of the second processing gas. Again, the processing-gas discharging mechanism may be constructed so that it has a gas discharging plate, a plurality of first gas discharging holes succeeding to the first gas supply pathway are arranged at the central part of the gas discharging plate part, and that a plurality of second gas discharging holes succeeding to the second gas supply pathway are arranged at the peripheral part of the gas discharging plate. Further, the gas discharging member may be provided, on its under surface alternately, with a plurality of first gas discharging holes succeeding to the first gas supply pathway and a plurality of second gas discharging holes succeeding to the second gas supply pathway. Moreover, the gas discharging mechanism is preferable to have a coolant passage formed in an area of the gas discharging plate where the gas discharging holes are formed. The coolant passage is formed so as to correspond to the shape of a gas discharging plate's part interposed among the plural gas discharging holes in the gas discharging plate's area where the gas discharging holes are formed. For instance, the coolant passage is formed concentrically. The processing-gas discharging mechanism may be provided with a heater. Further, it is preferable that the gas processing apparatus further comprises: a coolant flow piping arranged both in upstream of the coolant passage and in the downstream; a bypass piping connected, both in upstream of the processing-gas discharging mechanism and in the downstream, to the coolant flow piping while bypassing the processing-gas discharging mechanism; a pressure relief valve arranged on the downstream side of the coolant passage in the coolant flow piping; a group of valves defining a flowing pathway of the coolant; control means for controlling the group of valves; and a heater for heating the processing-gas discharging mechanism, wherein when cooling the processing-gas discharging mechanism, the control means controls the group of valves so as to allow the coolant to flow into the coolant passage, when heating the processing-gas discharging mechanism, the control means operates the heater and further controls the group of valves so as to stop the inflow of the coolant into the coolant passage and allow the coolant to flow into the bypass piping, and when lowering a temperature of the processing-gas discharging mechanism in its elevated condition in temperature, the control means controls the valves so as to allow the coolant to flow into both of the coolant passage and the bypass piping.

BRIEF DESCRIPTION OF THE DRAWINGS

Fig. 1A is a front view of a CVD film deposition apparatus in accordance with the first embodiment of the present invention.

Fig. 1B is a side view of the CVD film deposition apparatus in accordance with the first embodiment of the present invention.

Fig. 2 is a schematic sectional view showing a main body of the CVD film deposition apparatus of Figs. 1A and 1B.

Fig. 3 is a sectional view taken along a line A-A of the apparatus of Fig. 2.

Fig. 4 is a sectional view taken along a line B-B of the apparatus of Fig. 2.

Fig. 5 is a sectional view showing a joint part between a shower plate and a shower base in the CVD film deposition apparatus in accordance with the first embodiment of the present invention, in enlargement.

Fig. 6 is a view showing a top surface of the shower plate 35 in the CVD film deposition apparatus in accordance with the first embodiment of the present invention.

Fig. 7 is a sectional view showing the peripheral part of a lower part of the shower head in the apparatus of Fig. 2, in enlargement.

Fig. 8 is a sectional view showing the vicinity of the peripheral part of the lower part of the shower head in enlargement, in case of arranging the second gas discharging holes doubly.

Fig.9A is a view showing one example of the arrangement of the second gas discharging holes in enlargement, in case of arranging the second gas discharging holes doubly.

Fig.9B is a view showing another example of the arrangement of the second gas discharging holes in enlargement, in case of arranging the second gas discharging holes doubly.

Fig. 10 is a sectional view showing the vicinity of the peripheral part of the lower part of the shower head in enlargement, in case of arranging the second gas discharging holes obliquely.

Fig. 11 is a sectional view showing the vicinity of the peripheral part of the lower part of the shower head in enlargement, in case of arranging the second gas discharging holes inside the outer periphery of a wafer W obliquely.

Fig. 12 is a sectional plan view showing the other structure of the shower head.

Fig. 13 is a perspective view showing an interior structure of a casing of a gas introducing part of Fig.

2, in its exploded state.

Fig. 14 is a sectional view taken along a line C-C of the apparatus of Fig. 3.

Fig. 15 is a sectional view taken along a line D-D of the apparatus of Fig. 3.

Fig. 16 is a back view showing the opening-and-closing conditions of a lid body in the CVD film deposition apparatus shown in Figs. 1A and 1B.

Fig. 17 is a circuit diagram for explanation of a cooling control system used in the CVD film deposition apparatus in accordance with the first embodiment.

Fig. 18 is a graph where its horizontal axis represents the flow rate of $H_2$-gas, while the vertical axis represents the uniformity of W-film.

Fig. 19 is a graph showing the distribution of film thickness, which is obtained by measuring the thickness of W-film at respective measuring points 1 to 161 established along the diameter of a wafer W on film deposition as a result of changing the supply rate of $H_2$-gas to peripheral $H_2$-gas discharging holes variously and of which horizontal axis represents the measuring points, while the vertical axis represents the thickness of W-film at the respective measuring points.

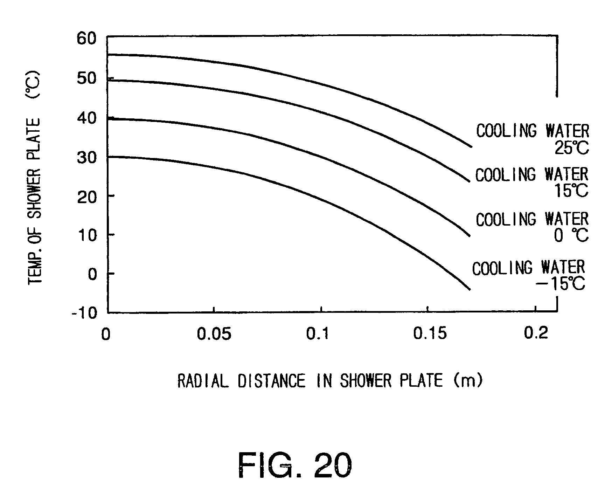

Fig. 20 is a view in cooling a shower head by using the conventional coolant passage, showing the relationship between the diametric position of a shower plate and its temperature at respective temperatures of cooling water.

Fig. 21 is a vertical sectional view showing a shower head part of the main body of a CVD apparatus in accordance with the second embodiment of the present invention.

Fig. 22 is a horizontal sectional view taken along a line E-E of Fig. 21, showing the shower head part of the main body of the CVD apparatus in accordance with the second embodiment of the present invention.

Fig. 23A is a sectional view showing the structure of a first circular passage in the shower head of Fig. 21.

Fig. 23B is a sectional view showing the structure of a third circular passage in the shower head of Fig. 21.

Fig. 24 is a sectional view showing the structure of a semiconductor wafer on which a W-film is formed by the apparatus in accordance with the second embodiment of the present invention.

Fig. 25 is a view for explanatory of an example of W-film formation flow carried out by the apparatus in accordance with the second embodiment of the present invention.

Fig. 26 is a sectional view showing a condition where an initial W-film is formed on a under barrier layer of the semiconductor wafer of Fig. 24.

Fig. 27 is a view showing a calculation example of the cooling condition of a shower plate of the apparatus in accordance with the second embodiment of the present invention.

Fig. 28 is a sectional view showing a condition where a main W-film is formed on the initial W-film on the under barrier layer of the semiconductor wafer of Fig. 26.

Fig. 29 is a sectional view showing a condition where a reactive intermediate represented by $SiH_x$ is formed by the application of an initiation processing on the under barrier layer of the semiconductor wafer of Fig. 26.

Fig. 30 is a sectional view showing a condition where a passivation W-film is formed on the first W-film of Fig. 26.

Fig. 31 is a sectional view showing another example of the coolant passage applied to the second embodiment of the present invention.

Fig. 32 is a sectional view showing a CVD apparatus in accordance with the third embodiment of the present invention.

Fig. 33A is a pattern diagram for explanation of the gas-flow in a $SiH_4$-gas supply process when forming a first W-film by using the apparatus of the third embodiment of the present invention.

Fig. 33B is a pattern diagram for explanation of the gas-flow in a $WF_6$-gas supply process when forming a first W-film by using the apparatus of the third embodiment of the present invention.

Fig. 34 is a schematic sectional view showing another example of the shower head of the third embodiment of the present invention.

Fig. 35 is a horizontal sectional view taken along a line F-F of Fig. 34.

## PREFERRED EMBODIMENTS FOR EMBODYING THE INVENTION

Referring to the attached drawings, embodiments of the present invention will be described in detail, below.

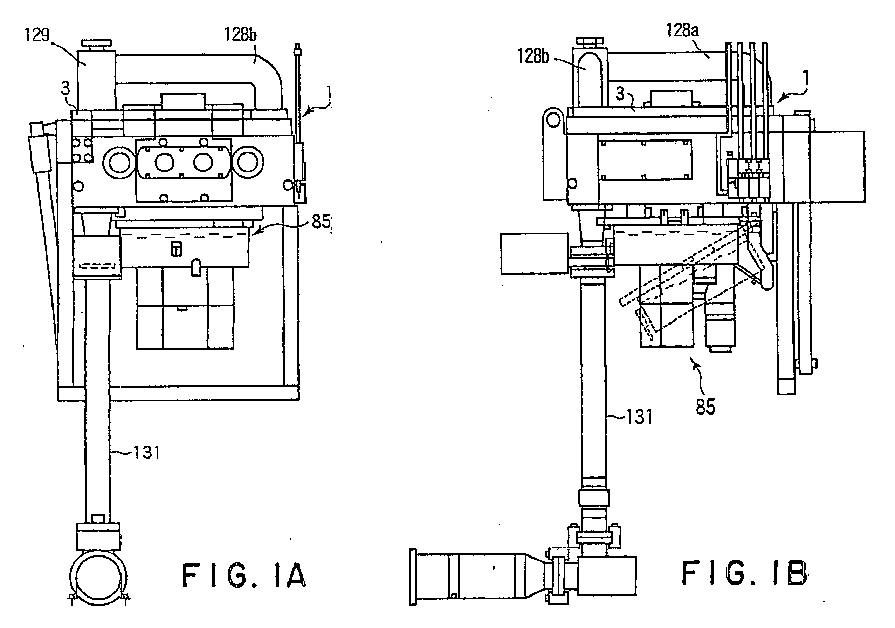

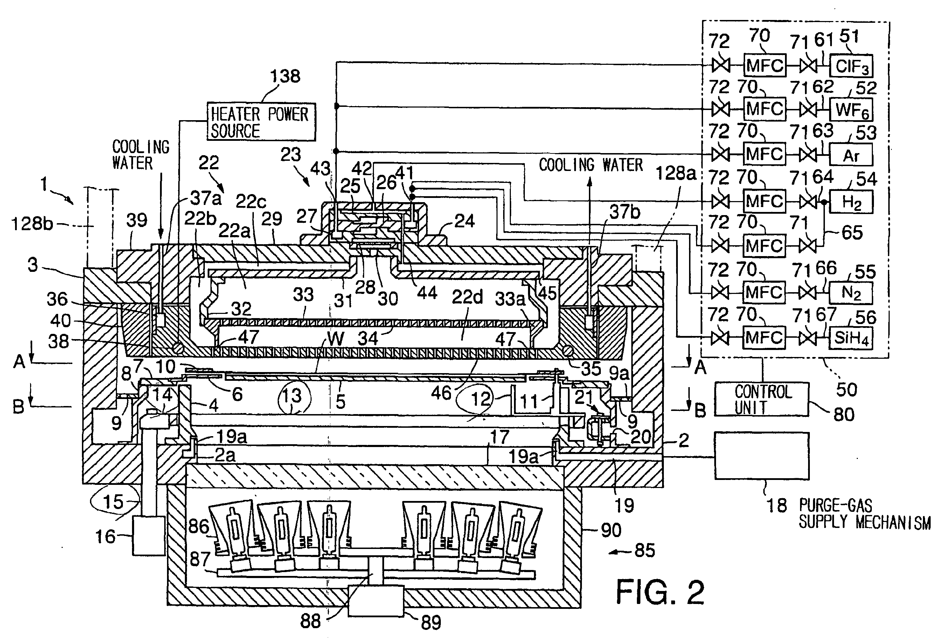

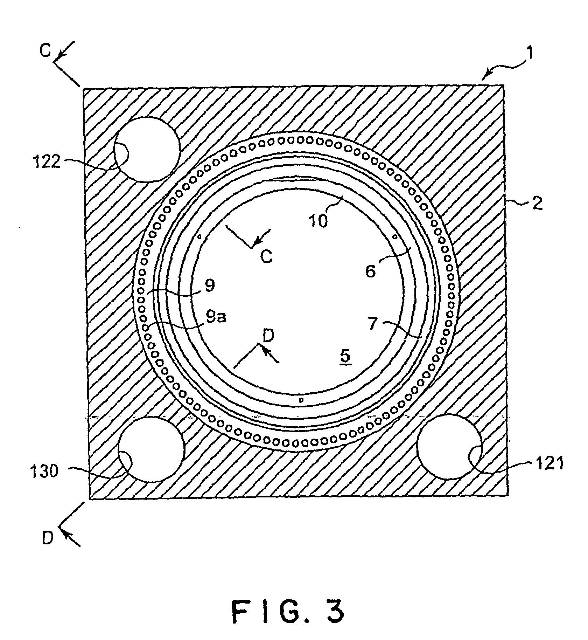

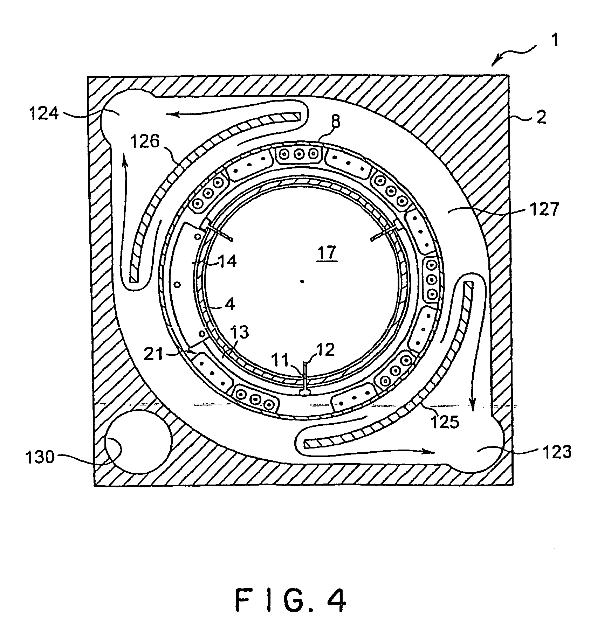

Fig. 1A is a front view of a CVD film deposition apparatus in accordance with the first embodiment of the present invention. Further, Fig. 1B is a side view of the same apparatus. Still further, Fig. 2 is a schematic sectional view of the CVD film deposition apparatus, Fig. 3 a sectional view taken along a line A-A of Fig. 2, and Fig. 4 is a sectional view taken along a line B-B of Fig. 2. This CVD film deposition apparatus is provided to form a tungsten (W) film on a semiconductor wafer W (simply referred "wafer W" below) as a substrate to be processed, with the used of $H_2$-gas and $WF_6$-gas.

As shown in Figs. 1A and 1B, this CVD film deposition apparatus has a main body 1. Under the main body 1, there is a lamp unit 85. On the top of the main body 1, a lid 3 supporting a shower head 22 described later is provided to be openable and closable. Further above the lid, upper exhaust pipes 128a, 128b are arranged so as to communicate with exhaust passages 121, 122 mentioned later, respectively. Again, below the main body 1, there is provided a lower exhaust pipe 131 that is connected to the main body 1 through a confluence part 129 interconnecting the upper exhaust pipes 128a, 128b connected thereto and an exhaust passage 130 mentioned later. This lower exhaust pipe 131 is arranged at the left corner of the front part of the main body 1 and also in a position to withdraw from the lamp unit 85.

As shown in Fig. 2, the main body 1 has a processing container 2 shaped to be a bottomed cylinder and made of e.g. aluminum etc. In the processing container 2, a cylindrical shield base 8 is provided to stand from the bottom of the processing container 2. Arranged on an opening in the upper part of the shield base 8 is an annular base ring 7 that supports an annular attachment 6 on the inner peripheral side of the ring 7. Being supported by gibbosity parts (not shown) projecting into the inner peripheral edge of the attachment 6, a mount table 5 is arranged to mount the wafer W thereon. A later-mentioned baffle plate 9 is arranged outside the shield base 8. Further, the afore-mentioned lid 3 is arranged on an opening in the upper part of the processing container 2, while a later-mentioned shower head 2 is arranged in a position opposing to the wafer W mounted on the mount table 5.

In a space surrounded by the mount table 5, the attachment 6, the base ring 7 and the shield base 8, a cylindrical reflector 4 is provided to rise from the bottom of the processing container 2. This reflector 4 is provided, in e.g. three locations, with slit parts (Fig. 2 shows one location). At positions corresponding to the slit parts, lift pins 12 for lifting up the wafer W from the mount table 5 are arranged so as to be movable up and down respectively. The lift pins 12 are supported by a drive rod 15 through an annular supporting member 13 and a joint 14 outside the reflector 4. The drive rod 15 is connected to an actuator 16. The lift pins 12 are formed by heat ray transmitting material, for example, quartz. Further, supporting members 11 are provided integrally with the lift pins 12. Penetrating the attachment 6, the supporting members 11 are adapted so as to support an annular clamp ring 10 above the attachment 6. The clamp ring 10 is formed by a cabonaceous component easy to absorb heat, such as amorphous carbon and SiC, or ceramics, such as $Al_2O_3$, AlN and black-AlN.

With the above-mentioned constitution, when the actuator 16 makes the drive rod 15 move up and down, both of the lift pins 12 and the clamp ring 10 move up and down integrally. When transferring the wafer W, the lift pins 12 and the clamp ring 10 are raised until the lift pins 12 project from the mount table 4 by a predetermined length. When mounting the wafer W carried on the lift pins 12 on the mount table 5, the lift pins 12 are withdrawn into the mount table 5, while the clamp ring 10 is lowered to a position to abut on the wafer W and further hold it, as shown in Fig. 2.

Into the space surrounded by the mount table 5, the attachment 6, the base ring 7 and the shield base 8, a purge gas from a purge-gas supply mechanism 18 is supplied through a purge-gas passage 19 formed in the bottom part of the processing container 2 and flow channel 19a that are disposed the inside and lower part of the reflector 4 at lieu interval to eight locations to communicate with the purge-gas passage 19. By allowing the so-supplied purge gas to flow radially-outwardly through a clearance between the mount table 5 and the attachment 6, a processing gas from the later-mentioned shower head 22 is prevented from invading to the backside of the mount table 5.

Additionally, the shield base 8 is provided, at several positions thereof, with openings 20. A plurality of pressure regulating mechanisms 21 are arranged on the inner peripheral side of the openings 20. When a pressure difference between an inside of the shield base 8 and the outside exceeds a predetermined value, the pressure regulating mechanisms 21 are activated to communicate the inside of the shield base 8 with the outside. Consequently, it is possible to prevent the clamp ring 10 from fluttering due to excessive pressure difference between the inside of the shield base 8 and outside and also possible to prevent any member into the container from being broken by an excessive force.

In the bottom part of the processing container 2 right under the mount table 5, an opening 2a is defined while the periphery is being surrounded by the reflector 4. A transmitting window 17 made of heat ray material, such as quartz, is fitted to the opening 2a in an airtight manner. The transmitting window 17 is held by a not-shown holder. A sapphire coating is applied on the surface of the transmitting window 17. The above lamp unit 85 is arranged below the transmitting window 17. The lamp unit 85 includes a heating chamber 90, a rotating table 87 in the heating chamber 90, lamps 86 attached to the rotating table 87 and a rotating motor 89 arranged in the bottom of the heating chamber 90 to rotate the rotating table 87 through a rotating shaft 88. Further, the lamps 86 are respectively provided with reflecting parts for reflecting their heat rays and also arranged so that the heat rays radiated from the respective lamps 86 uniformly reach the under surface of the mount table 5 directly or indirectly upon reflection of the inner periphery of the reflector 4. As this lamp unit 85 allows the lamps 86 to radiate the heat rays while making the rotating motor 89 rotate the rotating table 87, the heat rays emitted from the lamps 86 illuminates the under surface of the mount table 5 through the transmitting window 17, so that the mount table 5 is heated by the heat rays uniformly.

The shower head 22 includes a cylindrical shower base 39 formed so as to fit its outer periphery to the upper part of the lid 3, a plate shaped introducing plate 29 fitted to the upper part of the shower base 39 on its inner circumferential side and a shower plate 35 attached to the lower part of the shower base 39. The introducing plate 29 is provided, on its top, with a gas introducing part 23 mentioned later. A spacer ring 40 is arranged on the outer periphery of the shower plate 40.

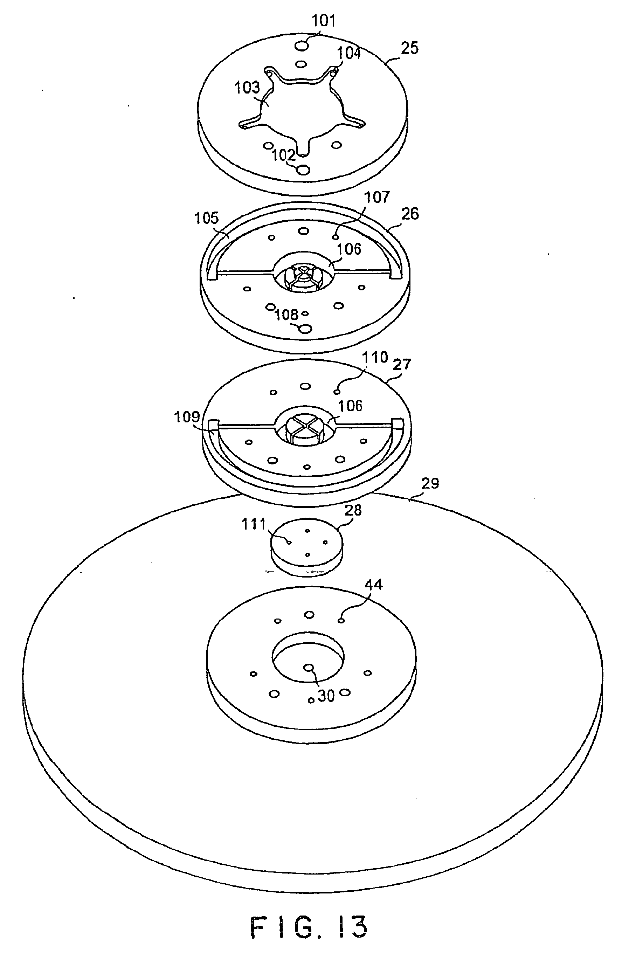

The introducing plate 29 is formed, at its center, with a first gas passage 30 for passage of a main gas. In the plate 29, a plurality of second gas passages 44A, for example, five passages (see Fig. 13, only one shown in Fig. 2) are formed so as to surround the first gas passage 30, for passage of a peripheral $H_2$-gas. Besides, regarding the number of the second gas passages 44, any number will do so long as they can make a uniform flow of the peripheral $H_2$-gas,.

An annular coolant passage 36 is formed in the peripheral portion of the upper part of the shower plate 35. This coolant passage 36 is supplied with cooling water as the coolant through a coolant supply path 37a, while the cooling water is discharged through a coolant discharging path 37b. In this way, the cooling water as the coolant is circulated. Consequently, at the film deposition, it is possible to cool the shower plate 35 to a predetermined temperature, for example, the order of $35°$ C, thereby suppressing the reaction of $SiH_4$-gas on the surface of the shower head 22. Note, a cooling control system employed at this cooling will be described later. Additionally, an annular heater 38 is embedded in the under side of the shower plate 35. This heater 38 is supplied with electricity from a heater power source 138. During the cleaning operation, if heating the shower plate 35 up to a predetermined temperature, for example, more than $160°$C by the heater 38, then it is possible to etch $ClF_3$ at a great etching rate. On the outer periphery of the shower plate 35, a spacer ring 40 is arranged in order to bill a gap between the shower plate 35 and a sidewall of the processing container 2.

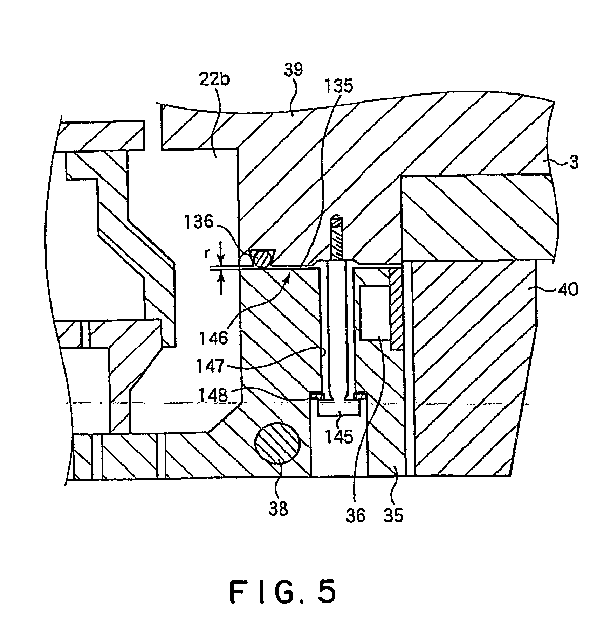

As shown in Fig. 5, a clearance (vacancy layer) 135 functioning as a heat insulating layer is defined between the shower plate 35 and the shower base 39. If such a clearance 135 is not provided, then heat of the heater 38 is transmitted to shower base 39 directly and the so-transmitted heat is easy to dissipated outside through the intermediary of the lid 3. In such a case, it will be required that the heater 35 has a great output. Especially, in an apparatus for processing a wafer of 300 mm in diameter, the shower head 22 will be large-sized remarkably. Then, under such a dispersion of heat, it becomes substantially impossible to heat the shower plate 35 to $160°$C or more, uniformly. To the contrary, according to the embodiment since the clearance 135 operates as an thermal insulation layer, it is possible to reduce such a heat dispersion remarkably, allowing the temperature of the shower plate 35 to be elevated to $160°$ C or more uniformly. A seal ring 136 is interposed between the shower plate 35 and the shower base 39 and also in their inner circumferential portions, in order to prevent a leakage of gas flowing from the shower head 22 to the outside via the clearance 135.

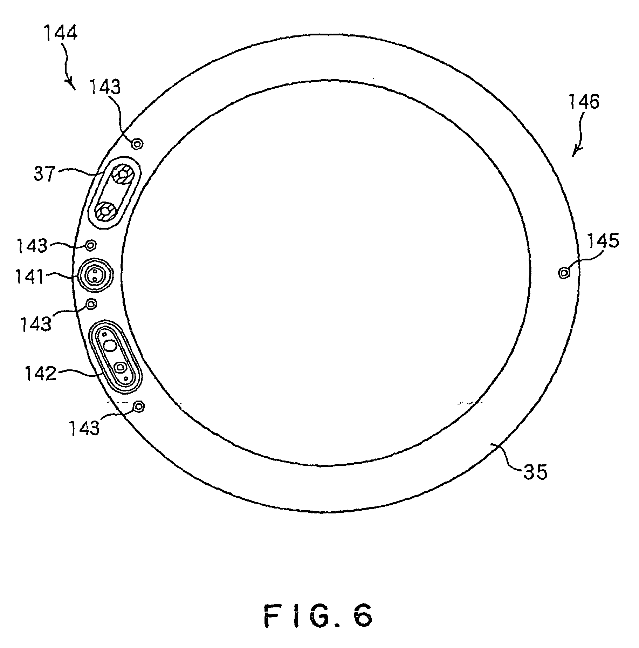

Fig. 6 is a view showing the top surface of the shower plate 35. As shown in this figure, on one side of the periphery of the shower plate 35, there are collectively arranged a coolant passage 37 for cooling wafer or the like, a thermocouple inserting part 141 and a heater terminal part 142. Thus, this side of the periphery of the shower plate 35 provides a fixing part 144 fixed to the shower base 39 through four bolts 143. In this fixing part 144, the coolant passage 37, the thermocouple inserting part 141 and the heater terminal part 142 are respectively sealed up so as not to be a leakage of the cooling water etc. The other side of the shower plate 35 provides a moving part 146 fastened to the shower base 39 by a bolt 145 so as to allow a relative displacement between the shower plate 35 and the shower base 39. In this moving part 146, as shown in Fig. 5, the diameter of a bolt inserting hole 147 is larger than the diameter of the bolt 145 by the order of 2 mm. A Teflon washer 148 is interposed between the bolt 145 and the shower plate 35. Consequently, when the shower plate 35 is heated to its thermal expansion by the heater 38 during the cleaning operation, it is possible to attain a positive slipping between the bolt 145 and the Teflon washer 148. In case of a film deposition apparatus for a wafer of 300 mm in diameter, if the shower base 35 at $35°$C during the film deposition is heated up to the order of $160°$C, then a thermal expansion of the shower plate 35 is on the order of 1 mm. Therefore, if the shower plate 35 is fixed to the shower base 39 completely, there is arises a strain between the shower plate 35 and the shower base 39, which causes various problems, for example, leakage of gas, shortage in life span of the apparatus, etc. While, by establishing a plate's part, which is not inconvenient for movement of the shower plate 35, as the moving part 146 capable of moving the shower base 39, it is possible to avert the negative impact derived from the thermal expansion of the shower plate 35. Additionally, owing to the interposition of the Teflon washer 148, a positive slippage arises between the bolt 145 and the shower plate 35. As a result, frictional wear is avoided between the shower plate 35 and the shower base 39 thereby producing no particle around them.

In a space in the shower head 22, which is surrounded by the shower base 39, the gas introducing plate 29 and the shower plate 35, there is a generally-circular horizontal partition 31 that is arranged just below the gas introducing plate 29 horizontally. In the inner circumferential part of the horizontal partition 31, a cylindrical gibbosity part 31a is formed so as to project upwardly. This cylindrical gibbosity part 31a is connected to the gas introducing plate 29.

On the other hand, a current plate 33 is arranged in the space in the shower head 22 while positioning its plate's surface horizontally. The current plate 33 is formed with a plurality of gas pass holes 34 and arranged at a predetermined distance from the shower plate 35 through a cylindrical spacer 33a. Further, a vertical partition 32 in the form of a cylinder is arranged between the outer periphery of the horizontal partition 31 and the spacer 33a.

Therefore, the inside space of the shower head 22 contains a spatial part 22a between the horizontal partition 31 and the current plate 33, a spatial part 22b between the shower base 39 and the vertical partition 32 and also the spacer 33a, a spatial part 22c between the gas introducing plate 29 and the horizontal partition 31 and a spatial part 22d between the current plate 33 and the shower plate 35. Among these parts, the spatial part 22b is communicated with the spatial part 22c through a clearance 45 formed between the horizontal partition 31 and the shower base 39. The first gas introducing hole 30 of the gas introducing plate 29 is communicated with the spatial part 22a, while the second gas introducing hole 44 is communicated with the spatial part 22c. However, the spatial part 22c is secluded from the spatial part 22a by the horizontal partition 31 and the gibbosity part 31a. Again, the spatial part 22b is secluded from the spatial part 22a by the vertical partition 32, while the spatial part 22b is secluded from the spatial part 22d by the spacer 33a. Noted, the current plate 33 may be formed integrally with the vertical partition 32.

At the center part of the shower plate 35, that is, in the plate's portion in the spatial part 22d, a plurality of first gas discharging holes 46 are formed to communicate with the spatial part 22d. At the outer peripheral part of the shower plate 35, that is, in the plate's portion facing onto the annular spatial part 22b, second gas discharging holes 47 for discharging the peripheral $H_2$-gas are formed so as to communicate with the spatial part 22b, circumferentially. Note, the first gas discharging holes 46 are arranged, for example, in a lattice pattern or radially. For example, the diameter of the first gas discharging hole 46 ranges from 0.1 to 5 mm, preferably, 1 to 3 mm. The second gas discharging hole 47 has a diameter similar to that of the first gas discharging hole. Besides, the diameter of the second gas discharging hole 47 may be larger or smaller than that of the first gas discharging hole 46.

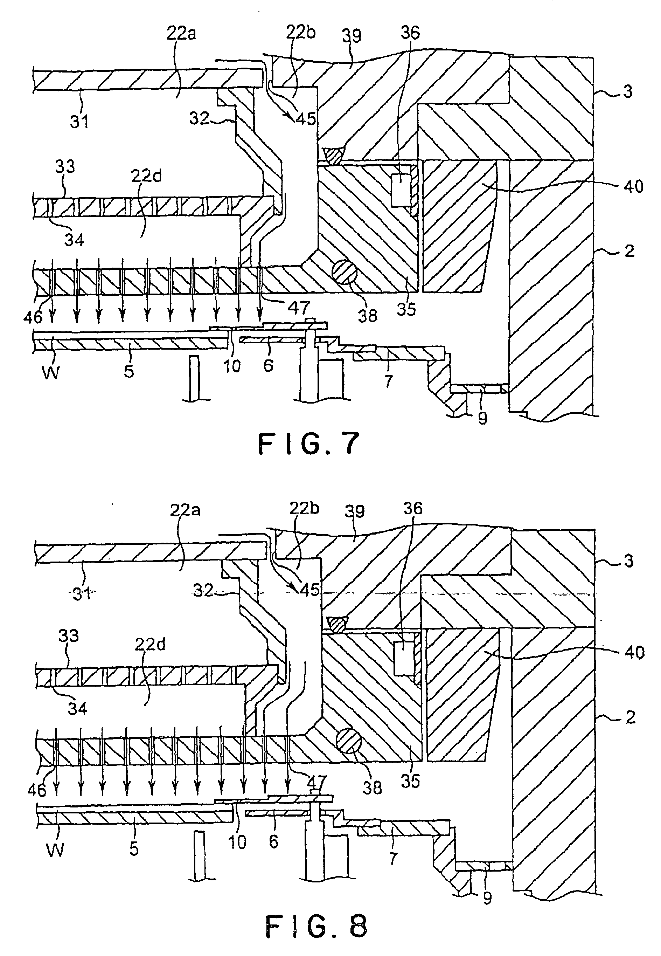

Fig. 7 is a partial enlarged view of the lower part of the shower head 22 in the embodiment, showing the currents of gases discharged from the first gas discharging holes 46 for discharging the main gas and the second gas discharging holes 47 for discharging the peripheral $H_2$-gas, in the form of arrows. As shown in Fig. 7, the main gas supplied from the first gas passage 30 flows from the spatial part 22a into the spatial part 22d through the gas passing holes 34 in the current plate 33 and subsequently, the main gas is discharged from the spatial part 22d to the wafer W vertically, through the first gas discharging holes 46 in the shower plate 35. While, $H_2$-gas from the second gas passage 44 flows from the spatial part 22c into the second spatial part 22b through the clearance 45 and subsequently, the $H_2$-gas is discharged from the second spatial part 22d to the outside portion (i.e. the side of the clamp ring) of wafer W vertically, through the second gas discharging holes 47 in the shower plate 35. The $H_2$-gas may be discharged to the peripheral part of the wafer W.

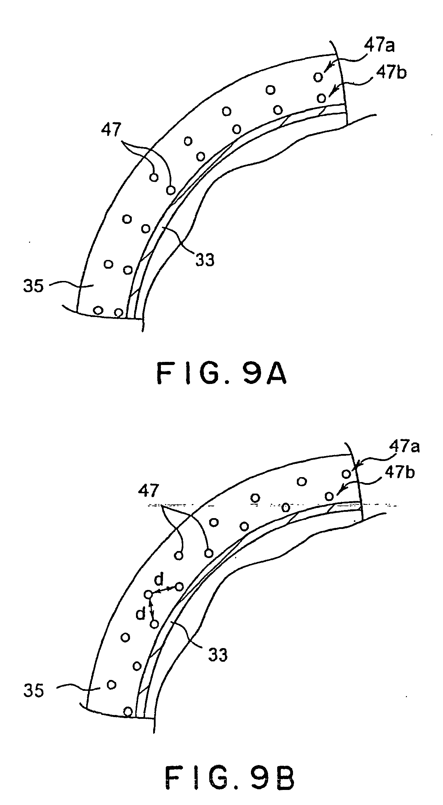

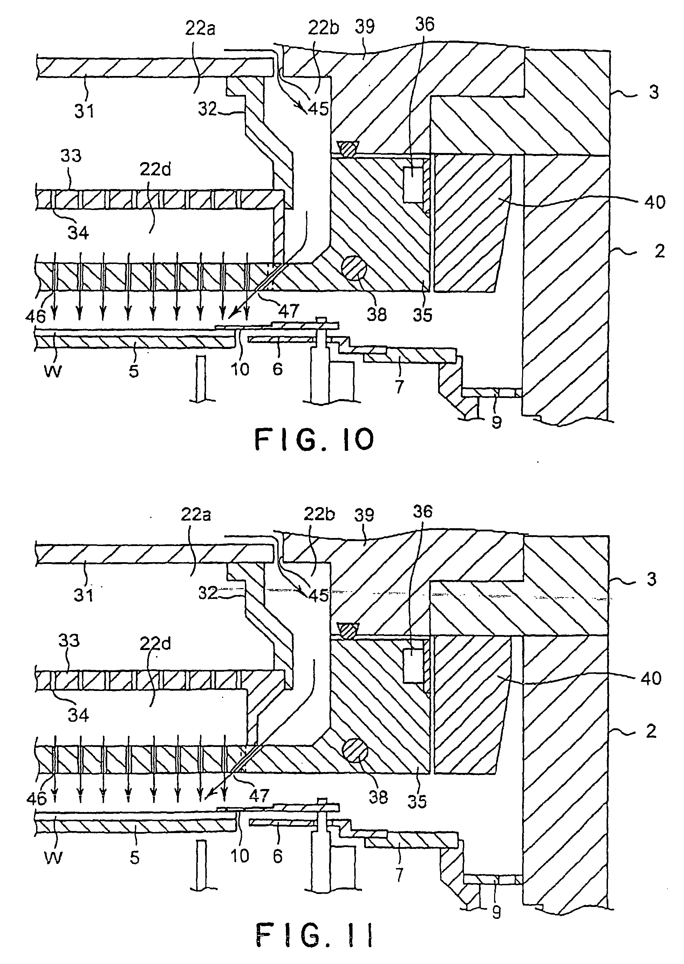

However, unlimitedly to only the arrangement of Fig. 7, the second gas discharging holes 47 may be arranged in a pattern to arrange them outside the outer peripheral margin of the wafer W in two lines concentrically, for example, as shown in Fig. 8. Alternatively, they may be arranged in three or more lines. Further, the second gas discharging holes 47 may be formed above the outer periphery of the wafer W in one line or outside the outer periphery of the wafer W in two or more lines. In case of the second gas discharging holes 47 in two or more lines, as shown in Fig. 9A, they may be arranged so that the second gas discharging holes 47 in adjacent lines 47a, 47b overlap each other. Or again, as shown in Fig. 9B, the second gas discharging holes 47 forming the adjacent lines 47a, 47b may be arranged alternately. Note, the alternate arrangement allows gas to be supplied more uniformly. In the alternate arrangement, as shown in Fig. 9B, it is desirable to arrange each of the second gas discharging holes 47 forming one line 47a in a position apart from two adjoining holes of the second gas discharging holes 47 forming the other line 47b by equal distances d. Additionally, as shown in Fig. 10, the second gas discharging holes 47 may be formed obliquely to the outer peripheral margin of the wafer W from its outside to the inside within the range of 0 to 45 degrees. Then, the diameter of the second gas discharging hole 47 ranges from 0.1 to 3 mm, preferably, 0.1 to 1.5 mm. Regarding the oblique arrangement of the second gas discharging holes 47, the discharge positions of the second gas discharging holes 47 are not limited to respective position outside the periphery of the wafer W only, as shown in Fig. 10. So long as the discharge positions are included in a range to allow formation of a uniform film, the discharge positions of the second gas discharging holes 47 may be respective position inside the periphery of the wafer W, as shown in Fig. 11.

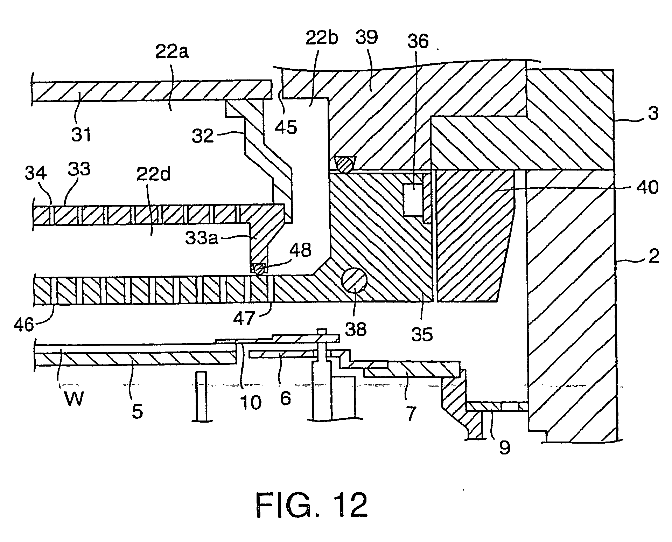

As mentioned above, the heater 38 is embedded in the shower plate 35, so that it is heated by the heater 38. In view of further preventing dispersion of heat due to heat transmission in heating the shower plate 35, as shown in Fig. 12, it is preferable to interpose a resinous seal ring 48 of heat-resistant resin, e.g. fluorocarbon resin between the spacer 33a of the current plate 11 and the shower plate 35, thereby accomplishing heat insulation.

Next, the aforementioned gas introducing part 23 will be described in detail.

The gas introducing part 23 includes a current plate 28 fitted to the top of the introducing plate 29, a lower plate 27, an intermediate plate 26 and an upper plate 25, all of which are stacked in order and accommodated in a casing 24. The casing 24 is provided, in its upper part, with a gas introductory port 42 connected to a later-mentioned gas supply mechanism 50 to introduce the peripheral $H_2$-gas and gas introducing ports 41, 43 for introducing the main gas

Fig. 13 is a perspective view showing the interior structure of the casing 24 in the above-mentioned gas introducing part 23. The upper plate 25 is provided with a cavity 103 communicating with the gas introducing port 42 of the casing 24, a passage 101 communicating with the gas introducing port 41 of the casing 24 and a passage 102 communicating with the gas introducing port 43 of the casing 24. On the bottom surface of the cavity 103, gas passage holes 104 for flow of the peripheral $H_2$-gas are formed at five locations in the circumference of the cavity 103. Through a groove 105 formed in the intermediate plate 26, the passage 101 in communication with the gas introductory port 41 is communicated with a vertical bore 106 formed in the intermediate plate 26 and the lower plate 27 successively. The passage 102 in communication with the gas introducing port 43 is communicated with the vertical bore 106 through a passage 108 formed in the intermediate plate 26 and a groove 109 formed in the lower plate 27. The vertical bore 106 is communicated with the first gas passage 30 at the center of the introducing plate 29 through current holes 111 of the current plate 28. With the constitution mentioned above, $H_2$-gas, $WF_6$-gas, etc. are mixed together in the vertical bore 106, so that the resulting mixed gas is supplied from the main gas passage 30. While, the gas passage holes 104 for flow of the peripheral $H_2$-gas are respectively communicated with gas passages 44 formed at five positions in the introducing plate 29 so as to surround the first gas passage 30, through a passage 107 in the intermediate plate 26 and another passage 110 in the lower plate 27.

In the above gas introducing part 23, gases supplied to the gas introducing ports 41, 43 are mixed together in the vertical bore 106 and successively supplied into the shower head 33 through the first gas passage 30. The peripheral $H_2$-gas supplied to the gas introducing port 42 is dispersed from the cavity 105 into five gas passage holes 104 and successively supplied into the shower head 22 through the second gas passage 44. Then, the gas supplied into the first gas passage 30 flows from the spatial part 22a in the shower head 33 to the spatial part 22d through the main-gas passing holes 34 of the current plate 33. In the spatial part 22d, the gas is diffused and further expired toward the wafer W through the main-gas discharge holes 46 uniformly. While, the peripheral $H_2$-gas supplied into the second gas passage 44 flows from the spatial part 22c in the shower head 33 to the spatial part 22b through the clearance 45 in the circumference of the plate-shaped partition 31. In the spatial part 22b, the gas is diffused and further expired toward the wafer W through the second gas discharge holes 47 uniformly. In this way, since the first gas discharge holes 46 and the second gas discharge holes 47 are supplied with gases respectively, it is possible to discharge different gases of different compositions through these discharge holes.

Next, the gas supply mechanism 50 will be described.

The gas supply mechanism 50 includes a $ClF_3$-gas supply source 51 for supplying $ClF_3$-gas as the cleaning gas, a $WF_6$-gas supply source 52 for supplying $WF_6$-gas as the W-content gas, an Ar-gas supply source 53, a $H_2$-gas supply source 54 for supplying $H_2$-gas as the reduction gas, a $N_2$-gas supply source 55 and a $SiH_4$-gas supply source 56 for supplying $SiH_4$-gas as the reduction gas.

A gas line 61 is connected to the $ClF_3$-gas supply source 51, a gas line 62 being connected to the $WF_6$-gas supply source 52, and a gas line 63 is connected to the Ar-gas supply source 53. These gas lines 61, 62 and 63 are connected to the gas introducing port 43 of the gas introducing part 23. Both of gas lines 64, 65 are connected to the $H_2$-gas supply source 54. In these gas lines 64 and 65, the gas line 64 is connected to the gas introducing port 42, while the gas line 65 is connected to the gas introductory port 41 of the gas introducing part 23. A gas line 66 is connected to the $N_2$-gas supply source 55, while a gas line 67 is connected to the $SiH_4$-gas supply source 56. These gas lines 66 and 67 are connected to the gas introducing port 41 of the gas introductory part 23. In these gas lines 61, 62, 63, 64, 65, 66 and 67, there are provided a mass-flow controller 70 and closing valves 71, 72 in front and behind, for each line. Note, in the gas supply mechanism 50, the gas supply using the valves etc. is controlled by a control unit 80.

While, as shown in Figs. 3 and 4, there is attached, between the shield base 8 and the sidewall of the processing container 8, the circular shaped baffle plate 9 that is provided, on its whole periphery, with exhaust holes 9a, as mentioned before. An annular exhaust space 127 is formed below this baffle plate 9. As shown in Fig. 4, below the baffle plate 9, exhaust spaces 123, 124 are arranged in positions forming opposing corners of the processing container 2. Arranged near an exhaust inlet of the exhaust space 123 is a bottom partition wall 125 that has a circular arc-shaped section, allowing the gas to be discharged through gaps between both ends of the partition wall 125 and the sidewall of the processing container 2. Further arranged near an exhaust inlet of the exhaust space 124 is a bottom partition wall 126 that has a circular arc-shaped section similarly, allowing the gas to be discharged through gaps between both ends of the partition wall 126 and the sidewall of the processing container 2.

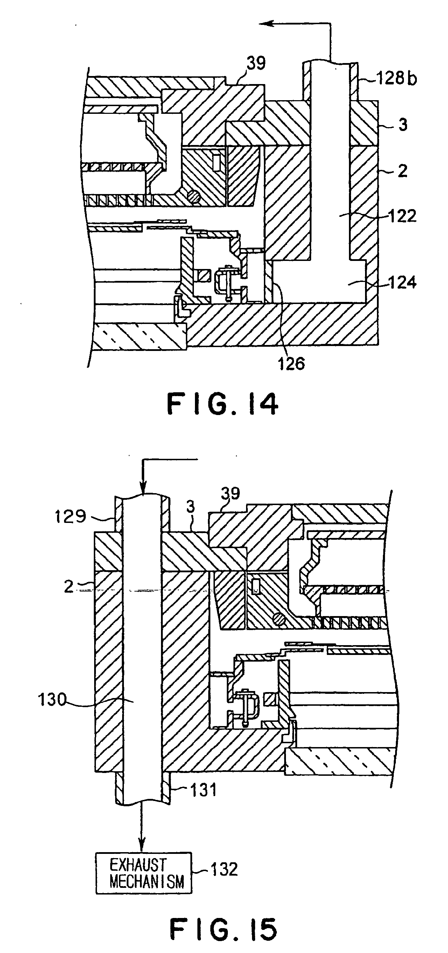

Next, a structure for exhausting the exhaust spaces 123, 124 will be described with reference to Figs. 14 and 15. Fig. 14 is a sectional view taken along a line C-C of Fig. 3, while Fig. 15 is a sectional view taken along a line D-D of Fig. 3. As shown in Fig. 14, the above-mentioned exhaust space 124 is communicated with one end of the exhaust passage 122 formed in the sidewall of the processing container 2 and the lid 3, while the other end of the exhaust passage 122 is connected to the upper exhaust pipe 128b.

As shown in Fig. 15, the upper exhaust pipe 128b is interconnected, at the other corner of the processing container 2, with a confluence part 129. This confluence part 129 is connected to the upper end of exhaust passage 130 that penetrates the lid 2 and the sidewall of the processing container 2. The lower end of the exhaust passage 130 is connected to an exhausting mechanism 132 through the lower exhaust pipe 131. Note, although Fig. 14 shows the structure in the vicinity of the exhaust space 124, the vicinity of the exhaust space 123 is provided with the similar structure. As shown in Figs. 1A and 1B, two upper exhaust pipes 128a, 128b connected to two points at the diagonal positions of the processing container 2 are interconnected, at the other corner of the processing container 2, to the confluence part 129 and further join to one exhaust passage 130 through the confluence part 129. The exhaust passage 130 is further connected to the exhaust mechanism 132 through one lower exhaust pipe 131 below the processing container 2. Then, by operating the exhaust mechanism 132, the atmosphere in the processing container 2 is discharged from the exhaust holes 9a in the baffle plate 9 into the annular exhaust space 127 below the plate 9 and discharge the exhaust spaces 123, 124 through the passage between both ends of the bottom partition wall 125 and the sidewall surface of the processing container 2 and the passage between both ends of the bottom partition wall 126 and the sidewall surface of the processing container 2. Then, the atmosphere is discharged upward through the exhaust passages 121, 122 and further discharged downward from the upper exhaust pipe 128 through the exhaust passage 130. In this way, by discharging the atmosphere in the processing container 2, it becomes possible to depressurize the interior of the processing container 2 to a designated vacuum.

At this time, since the atmosphere flowing from the exhaust holes 9a of the baffle plate 9 into the underside annular exhaust space 127 flows as shown with arrow of Fig. 4 while making a detour to avoid the bottom partition walls 125, 126, the atmosphere flowing out of the exhaust holes 9a in the vicinity of the exhaust spaces 123, 124 is prevented from being discharged directly, allowing the atmosphere to be discharged from the respective exhaust holes 9a approximately uniformly. Accordingly, the atmosphere in the processing container 2 is exhausted from the outer periphery of the mount table 5 uniformly. Additionally, according to the above constitution, since the interior of the processing container 2 can be exhausted through the single lower exhaust pipe 131 arranged in a position to avoid the lamp unit 85 at the lower part of the processing container 2, it is possible to simplify the structure of the lower part of the processing container 2. Therefore, it is possible to attempt the miniaturization of the CVD film deposition apparatus and also possible to carry out maintenance of the apparatus, for example, exchange of the lamps 86 in the lamp unit 85 arranged below the processing container 2, with ease.

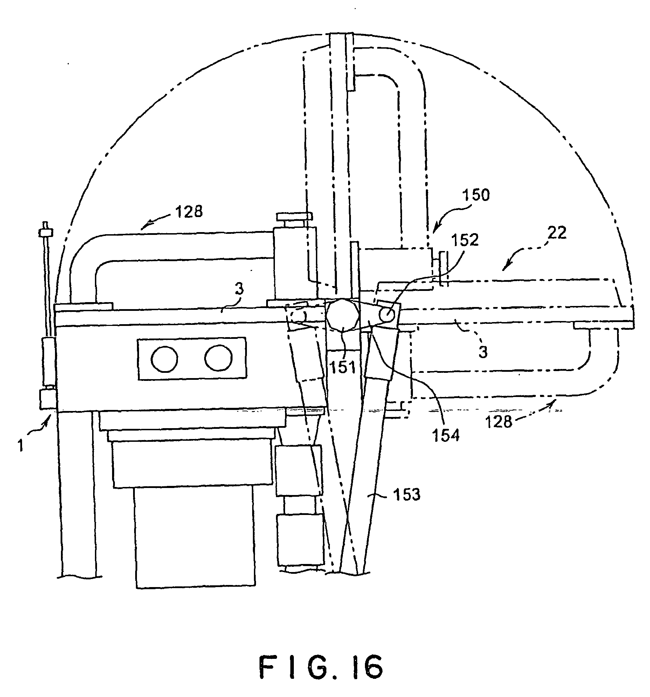

Next, a supporting mechanism in opening and closing the lid 3 of this CVD film deposition apparatus will be described with reference to Fig. 16. Fig. 16 is a back view of the CVD film deposition apparatus. As shown in Fig. 16, the shower head 22 is attached to the center of the lid 3. Because of a considerable weight of the shower head 22, a supporting mechanism 150 is provided on the lateral side of the lid 3. The supporting mechanism 150 includes an arm 154 which is attached to a rotating shaft 151 for rotating the lid 3 as shown with an imaginary line of Fig. 16 so as to oppose the lid 3 and a rod member 153 having its one end engaged with a shaft 152 on the arm 154, which has a maximum length at positions shown with a solid line and an imaginary line of Fig. 16 and which is expandable within a range shorter than the maximum length. When closing the lid 3, the rod member 153 and the arm 154 are positioned on the right side of the lid 3 as shown with the solid line of Fig. 16. From this state, when rotating the lid 3 as shown with the imaginary line of Fig. 16, the rotating shaft 151 and the arm 154 in cooperation with the rotation rotate in the clockwise direction integrally, so that the rod member 153 expands and contracts while following the arm 154. As shown with the imaginary line of Fig. 16, when the lid 3 rotates with an angle of 180 degrees, the arm 154 rotates up to a position where the rod member 153 on the left side of the rid 3 has the maximum length. At the position, the rotations of the rotating shaft 151 and the arm 154 are locked up by the rod member 153, so that the lid 3 is maintained in its opened state as a result of rotating with the angle of 180 degrees. Owing to the provision of the so-constructed supporting mechanism 150 on the lateral side of the lid 3, it becomes possible to open and close the rid 3 equipped with the shower head 22 of heavyweight with ease, whereby the maintenance property of the CVD film deposition apparatus can be improved.

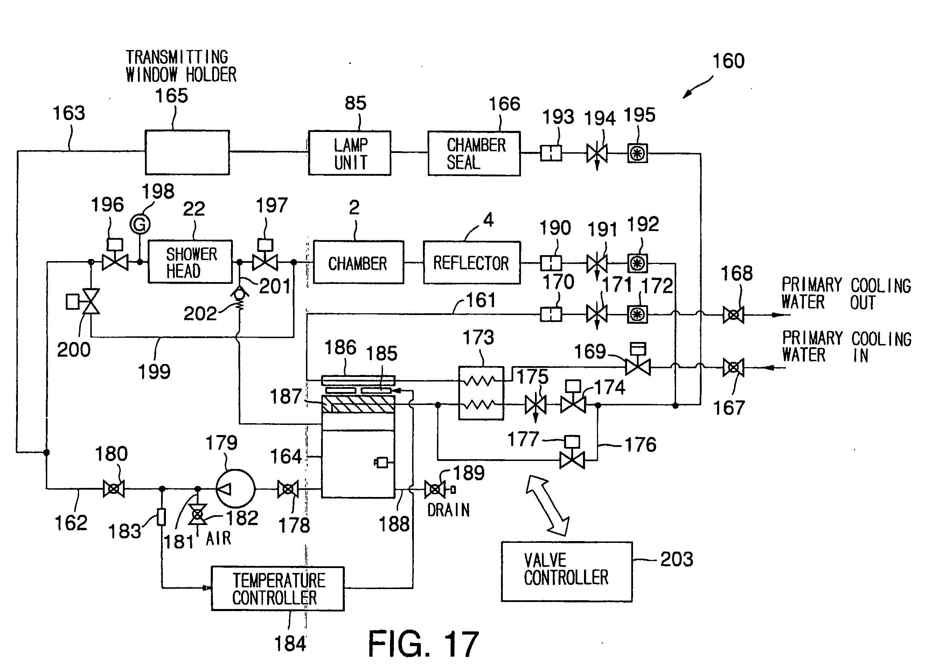

Next, the cooling control system used for the main body 1 of the CVD film deposition apparatus of this embodiment will be described with reference to Fig. 17. This cooling control system 160 includes a primary coolant piping 161 for circulating a primary coolant, such as tap water (city water), a first secondary coolant piping 162 where a secondary coolant having its temperature controlled as a result of heat exchange with the primary coolant piping 161 does circulate and a second secondary coolant piping 163 which is diverged from the first primary coolant piping 162 to allow the similar secondary coolant to circulate. The secondary coolant is stored in a secondary coolant tank 164 and the so-stored secondary coolant circulates the first secondary coolant piping 162 and the second secondary coolant piping 163.

The secondary coolant circulating in the first secondary coolant piping 162 flows through the shower head 22, the chamber 2 (chamber wall) and the reflector 4 in order from the upstream side, while the same water in the second secondary coolant piping 163 flows through a transmitting window holder 165 (not shown in Fig. 2) holding the transmitting window 17, the lamp unit 85 and a chamber seal 166 (not shown in Fig. 2), such as seal ring, for sealing up the chamber 2 in order from the upstream side.

The primary coolant piping 161 includes a ball valve 167 on the inlet side and a ball valve 167 on the outlet side. A solenoid valve 169 is arranged near the "inlet-side" ball valve 167 and on its downstream side. Near the "outlet-side" ball valve 168 and on its upstream side, there are arranged a strainer 170, a needle valve 171 and a flow meter 172 in order from the upstream side. Further, on the downstream side of the solenoid valve 169, a heat exchanger 173 is arranged to perform heat exchange between the primary coolant and the secondary coolant.

In a non-branching part of the first secondary coolant piping 162 and on the upstream side of the secondary coolant tank 164, there are provided an air operation valve 174, a needle valve 175 and the above heat exchanger 173, in order from the upstream side. Further, a bypass piping 176 for bypassing these elements is arranged in the non-diverging part. In the non-branching part of the first secondary coolant piping 162 and on the downstream side of the secondary coolant tank 164, there are provided a ball valve 178, a pump 179 for circulating the secondary coolant and a ball valve 180, in order from the upstream side. An air draft piping 181 for the pump 179 is arranged on the downstream side of the pump 179. The air draft piping 181 is provided with a ball valve 182.

Above the secondary cooling water tank 164, there are a heater 185 and a cooling plate 186 where the primary coolant circulates. The secondary coolant tank 164 is provided, in its upper part, with a control part 187 where the first secondary coolant piping 162 is arranged. While, on the downstream side of the pump 179 in the first secondary coolant piping 162, a thermocouple 183 is arranged to detect a temperature of the secondary coolant. Detection signals from the thermocouple 183 are inputted to a temperature controller 184. Controlling the output of the heater 185, the temperature controller 184 is adapted so as to control the temperature of the secondary coolant flowing through the control part 185 to a desired temperature due to the balance between heating by the heater 185 and cooling by the cooling plate 186. Note, the secondary coolant tank 164 is provided, in its bottom part, with a drain piping 188 having a ball valve 189.

On the downstream side of the reflector 4 in the first secondary coolant piping 162, there are arranged a strainer 190, a needle valve 191 and a flow meter 192, in order from the upstream side. Additionally, on the downstream side of the chamber seal 166 in the second secondary coolant piping, there are arranged a strainer 193, a needle valve 194 and a flow meter 195, in order from the upstream side.

In the shower head 22, the first secondary coolant 162 is connected to both inlet side and outlet side of the above-mentioned coolant passage 36. The first secondary coolant piping 162 is provided, on the upstream and downstream sides, with air operation valves 196, 197, respectively. A pressure gauge 198 is arranged between the air operation valve 196 of the first secondary coolant piping 162 and the shower head 22. Further, a bypass piping 199 for bypassing the shower head 22 is connected to a part of the first secondary coolant piping 162 on the upstream side of the air operation valve 196 and another part of the piping 162 on the downstream side of the air operation valve 197. The bypass piping 199 is provided, on its inlet side, with an air operation valve 200. A piping 201 flowing the secondary coolant tank 164 is connected to a part of the first secondary coolant piping 162 between the shower head 22 and the air operation valve 197. The piping 201 is provided with a pressure relief valve 202. Note, all of the above valves are controlled by a valve controller 203.

Next, the operation of the above-constructed CVD film deposition apparatus to form a W-film on the surface of a wafer W will be described.

First, it is performed to open a not-shown gate valve on the sidewall of the processing container 2 and load a wafer W into the processing container 2 by a transfer arm. Next, after raising the lift pins 12 so as to gibbosite from the mount table 5 by a predetermined length and further receiving the wafer W, it is performed to withdraw the transfer arm from the processing container 2 and further close the gate valve. Next, it is performed to lower the lift pins 12 and the clamp ring 10 and make the lift pins 12 go under the mount table 5 to mount the wafer W thereon. Additionally, it is carried out to lower the clamp ring 10 to a position to abut on the wafer W and hold it. Further, the exhaust mechanism 132 is operated to depressurize the interior of the processing container 2 into a high vacuum condition. Then, while rotating the rotating table 87 by the rotating motor 89, it is performed to light on the lamps 86 in the heating chamber 90 to radiate heat rays, thereby heating the wafer W for a predetermined temperature.

Next, in order to apply the initiation process on the wafer W, it is performed to supply respective processing gases from the Ar-gas supply source 53, the $N_2$-gas supply source 55 and the $SiH_4$-gas supply source 56 of the gas supply mechanism 50 at respective flow rates. Further, the gas lines 64, 65 are supplied with $H_2$-gas from the $H_2$-gas supply source 54, at respective designated flow rates. Consequently, the mixture gas of Ar-gas, $N_2$-gas, $SiH_4$-gas and $H_2$-gas is discharged from the first gas discharging holes 46 of the shower head 22 toward the wafer W thereby allowing the wafer W to absorb Si. Therefore, at the next step, a nucleation film is formed on the wafer effectively and uniformly. $H_2$-gas may be expired from the second gas discharging holes 47 toward the periphery of the wafer W. Further, by starting supply of purge gas from the purge-gas supply mechanism 18, it is performed to prevent the processing gas from making a warparound for the backside of the mount table 5.

After the initiation processing, while maintaining the above flow rates of the respective processing gases, it is performed to start the supply of $WF_6$-gas from the $WF_6$-gas supply source 52 at a predetermined flow rate smaller than that in a main film deposition process mentioned later, thereby adding $WF_6$-gas to the gas expired from the first gas discharging holes 46. In this state, it is performed to proceed with reducing reaction of a $SiH_4$-gas shown in the following formula (1) for a predetermined period, thereby forming a nucleation film on the surface of the wafer W.

$$2WF_6 + 3SiH_4 \rightarrow 2W + 3SiF_4 + 6H_2 \qquad (1)$$

Subsequently, it is performed to stop the respective supply of $WF_6$-gas, $SiH_4$-gas and $H_2$-gas from the second gas discharging holes 47 and also increase the supply amounts of Ar-gas, $N_2$-gas and $H_2$-gas from the first gas discharging holes 46 thereby purging the processing gas for forming the nucleation film. Additionally, the exhaust amount of the exhaust mechanism 132 is lowered to enhance a pressure inside the processing container 2 for the main film deposition process and the temperature of the wafer W is stabilized.

Next, it is performed to restart the supply of $WF_6$-gas and $H_2$-gas from the second gas discharging holes 47 and further reduce the supply amounts of Ar-gas, $N_2$-gas and $H_2$-gas from the first gas discharging holes 46. In this state, it is performed to proceed with the formation of W-film by the $H_2$-gas reducing reaction shown in the following formula (2) for a predetermined period, thereby performing the main film deposition process to form a W-film on the surface of the wafer W.

$$WF_6 + 3H_2 \rightarrow W + 6HF \qquad (2)$$

After completing the main film deposition process, it is carried out to stop the supply of $WF_6$-gas and further depressurize the interior of the processing container 2 by the exhaust mechanism 132 quickly while maintaining the supply of Ar-gas, $H_2$-gas and $N_2$-gas, thereby purging the residual processing gas on completion of the main film deposition process from the processing container 2. Next, while stopping all the supply of gases, the depressurizing is maintained to form a high vacuum in the processing container 2. Thereafter, it is carried out to raise the lift pins 12 and the clamp ring 10 in order to allow the lift pins 12 to gibbosite from the mount table 5 thereby raising the wafer W up to a position to allow the transfer arm to receive the wafer W. Then, the gate valve is opened and the transfer arm insert into the processing container 2 to receive the wafer W on the lift pins 12. Next, by the withdrawal of the transfer arm from the processing container 2, the wafer W is discharged therefrom, so that the film deposition process is completed.

According to the process as above, by dis-

charging $H_2$-gas from second gas discharging holes 47 onto the peripheral side of the wafer W while discharging the mixture gas containing $WF_6$-gas and $H_2$-gas from the first gas discharging holes 46 onto the central side of the wafer W in the initiation process, the nucleation process and the main film deposition process, it is possible to prevent the concentration of $H_2$-gas from being lowered on the peripheral side of the wafer W, whereby the wafer W can be formed with a W-film being uniform in film thickness.

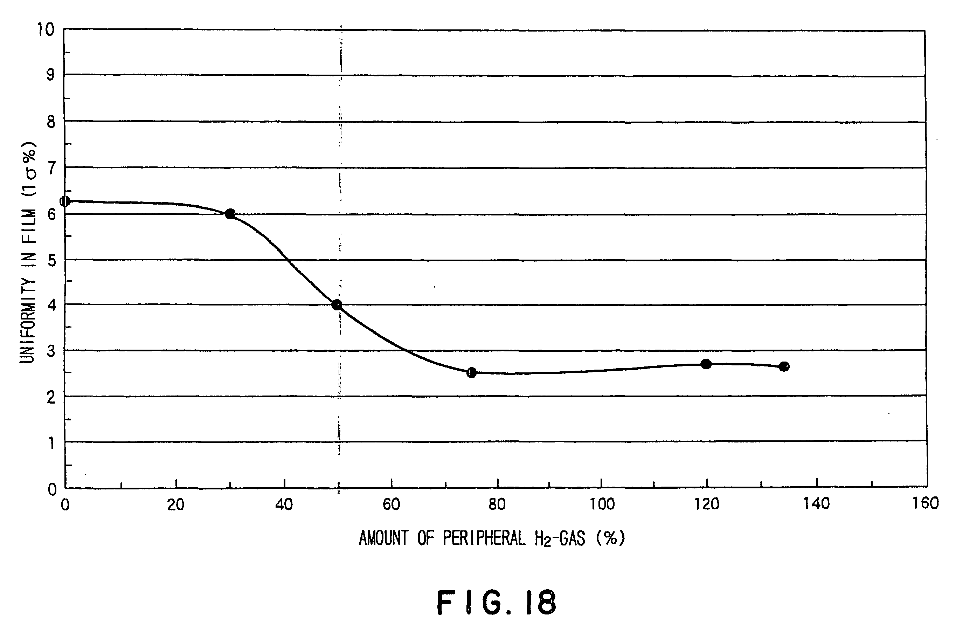

Fig. 18 is a graph showing an investigation result in the uniformity of a W-film formed on the wafer W by changing the flow rate of $H_2$-gas expired from the second gas discharging holes 47 within a range from 0 to 135% of the flow rate of $H_2$-gas discharged from the first gas discharging holes 46, in the main film deposition process of the above process. In the graph, a horizontal axis designates the flow rate of $H_2$-gas discharged from the second gas discharging holes 47, while the vertical axis represents the uniformity of W-film. From Fig. 18, it will be found that an effect to improve the uniformity of W-film becomes remarkable when establishing the flow rate of $H_2$-gas discharged from the second gas discharging holes 47 to be more than 50 % of the flow rate of $H_2$-gas discharged from the first gas discharging holes 46. The more preferable flow rate of $H_2$-gas from the second gas discharging holes 47 is more than 60 % of the flow rate of $H_2$-gas expired from the first gas discharging holes 46.

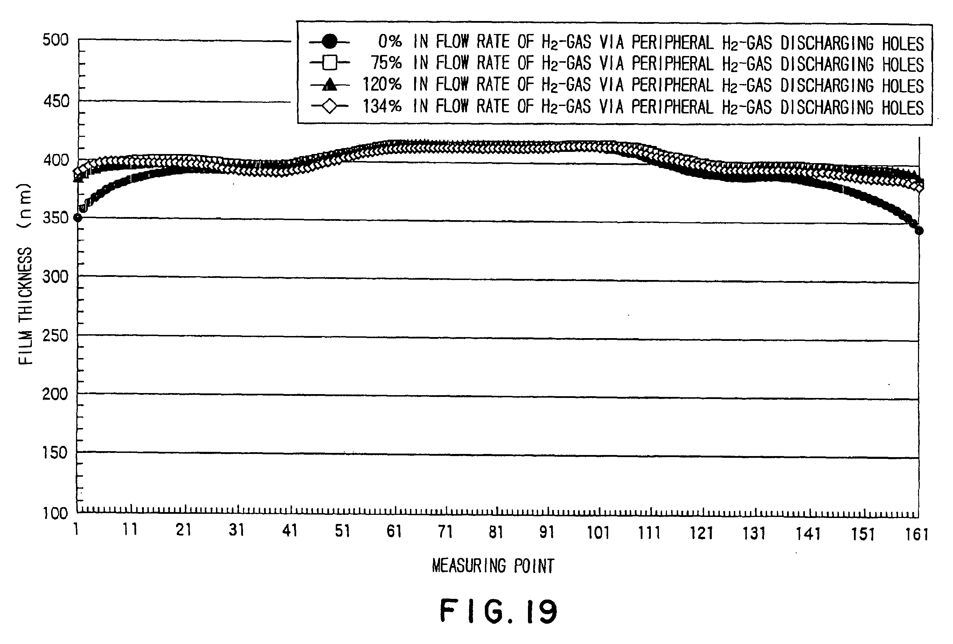

Fig. 19 is a graph showing the distribution of film thickness as a result of measuring the thickness of W-films on the wafers W at respective measuring points 1 to 161 established along the diameter of the wafers W having W-films formed by changing the flow rate of $H_2$-gas discharged from the second gas discharging holes 47 within a range from 0 to 134 % of the flow rate of $H_2$-gas discharged from the first gas discharging holes 46. In the graph, a horizontal axis designates respective measuring points, while the vertical axis represents the film thickness of W-film at the respective measuring points. From Fig. 19, it is confirmed that when no $H_2$-gas is discharged from the second gas discharging holes 47, the film thickness of W-film gets thin on the periphery of the wafer W, so that the film deposition of uniform W-film in film thickness cannot be accomplished and that when $H_2$-gas is discharged from the second gas discharging holes 47, the film thickness of W-film is prevented from getting thin on the periphery of the wafer W. Further, as a result of examining the quality of W-film formed on the wafer W in ease case, it is confirmed that the most high quality of W-film can be obtained when setting the flow rate of $H_2$-gas discharged from the second gas discharging holes 47 to be 134 % of the flow rate of $H_2$-gas discharged from the first gas discharging holes 46.

In each of the cases of:; providing, outside the outer margin of the wafer W, with the peripheral $H_2$-gas discharging holes 47 perpendicularly in a line, as shown in Fig. 7 (referred "H1" below); providing, outside the outer margin of the wafer W, with the peripheral $H_2$-gas discharging holes 47 perpendicularly in two lines, as shown in Fig. 8 (referred "H2" below); and providing, outside the outer margin of the wafer W, with the peripheral $H_2$-gas discharging holes 47 obliquely, as shown in Fig. 10 (referred "H4" below), the film deposition of W-film was carried out while discharging $H_2$-gas from the second gas discharging holes 47. Further, for comparison, the film deposition of W-film was carried out in the similar process but discharging no $H_2$-gas from the second gas discharging holes 47 (shown "conventional" below). As a result of comparing the uniformity of respective W-films obtained in the above way, it is confirmed that the case H1 exhibits the most high uniformity, the case "H2" the second uniformity, the case "H4" the third uniformity, and the case "conventional" case exhibits the worst uniformity. Consequently, it is confirmed that it is desirable to arrange the second gas discharging holes 47 outside the outer margin of the wafer W perpendicularly.

After picking out the wafer W on completion of the film deposition process, it is carried out to supply $ClF_3$-gas into the processing container 2 as occasion demands, for example, after processing at least one wafer, thereby performing a cleaning operation to remove unnecessary adhesive agents adhering to the interior of the processing container 2. Additionally, as occasion demands, for example, after the film deposition process of at least several lots is finished, a flashing process is carried out besides the normal cleaning. In the flashing process, while supplying $ClF_3$-gas into the processing container 2, the shower plate 35 is heated to a temperature more than 160°C by the heater 38. As a result, the reactivity of reaction by-product materials containing $TiF_X$ adhering to the shower head 22 with $ClF_3$-gas is enhanced to remove the by-product materials containing $TiF_X$ with an increased etching rate of the by-product materials. In connection, it is noted that since the temperature of the shower head at the normal cleaning is less than e.g. 100°C, the reaction by-product materials containing $TiF_X$ are not removed but deposited.

In this case, since the gap (vacancy layer) 135 functioning as a thermal insulation layer is defined between the shower plate 35 and the shower base 39, the heat of the heater 38 is difficult to be transmitted to the shower base 9 directly and dissipated through the lid 3. Accordingly, without excessive output of the heater 38, it is possible to heat the shower plate 35 up to a temperature more than 160°C, which is suitable for cleaning.

The moving part 146 of the shower plate 35 is fastened to the shower base 39 by the bolt 145 so as to allow the relative displacement between the shower plate 35 and the shower base 39. That is, since the diameter of the bolt insertion hole 147 is larger than the diameter of the bolt 145 by the order of 2 mm and the Teflon washer 148 is interposed between the bolt 145 and the shower plate 35, when the shower plate 35 is heated by the heater 38 and expanded thermally during the cleaning operation, it is possible to attain a positive slipping between the bolt 145 and the Teflon washer 148. Therefore, for example, even when the shower base 35 is heated from 35°C during the film deposition process to approx. 160° C and expanded thermally by approx. 1 mm in the film deposition apparatus for wafers of 300 mm in diameter, it is possible to prevent an occurrence of problems that would be caused if the shower plate 35 is fixed to the shower base 39 completely, for example, gas leakage due to strains of the shower plate 35 and the shower base 39, shortage in life span of the apparatus, etc. Additionally, as the positive slippage is produced between the bolt 145 and the shower plate 35 by the Teflon washer 148, it is possible to avoid wear between the shower plate 35 and the shower base 39, whereby almost no particle is produced. In this case, as the bolt 145, it is preferable to employ a shoulder bolt as shown in Fig. 5. Consequently, even if no management is applied to a tightening torque of the bolt, a distance r of the gap 135 is severely guaranteed to make a uniform tightening pressure between the shower plate 35 and the shower base 39 with no dispersion.

On the other hand, during the film deposition, the cooling control system 160 cools respective members in the main body 1 of the CVD film deposition apparatus, as mentioned above. In the cooling operation, by cooling the shower head 22 in order to suppress the reaction of $SiH_4$ on the surface of the shower head 22, the adhesion of product materials to the shower head is prevented. Nevertheless, it is noted that reaction by-product materials containing $TiF_X$ adheres to the shower head. Therefore, since there is a need for the heater 38 to rise the temperature of the shower head 22 at cleaning, particularly at flashing, up to a high temperature of 160°C at which the reaction by-product materials containing $TiF_X$ are removed, the coolant passage 36 coexists with the heater 38 in the shower head 22. In general, when a coolant passage coexists with a heater in the above way, both heating and cooling are deteriorated in their efficiencies.

To the contrary, according to this embodiment, it is possible to cancel such a problem by allowing the valve controller 203 in the cooling control system 160 of Fig. 17 to control various valves as follows.

First, during the film deposition process, the air operation valves 196 and 197 are opened, while the air operation valve 200 is closed. In this state, it is performed to allow the secondary coolant to flow from the second secondary coolant piping 162 to the coolant passage 36 in the shower head 22.

When heating the shower head 22 for the flashing process succeeding to the film deposition, the heater 38 is operated and the air operation valves 196 and 197 are together closed to stop the inflow of the secondary cooling water into the coolant passage 36 in the shower head 22, while the air operation valve 200 is opened to allow the secondary coolant to flow through the bypass piping 199. At this time, water remained in the coolant passage 36 is boiled due to heating by the heater 38. Consequently, the pressure relief valve in the piping 201 is cracked, so that the water in the coolant passage 36 is forced to the secondary coolant tank 164. Consequently, it is possible to force the water in the coolant passage 36 quickly, allowing the heating to be carried out with high efficiency.

On the other hand, when lowering the temperature of the shower head 22 that has been heated highly, the air operation valve 196 and 197 are opened while leaving the air operation valve 200 as it is opened. While, if the air operation valve 196 and 197 are opened after closing the air operation valve 200, the secondary coolant is vaporized by the shower head 22 of high temperature, so that only steam flows into the first secondary coolant piping 162 on the downstream side of the shower head 22. In such a case, the flow meter 192 is inactivated to exhibit an error. Additionally, due to the flowing of steam of high temperature, it becomes difficult to use a Teflon (trade mark) tube that is being in heavy usage as this kind of piping normally. To the contrary, by thus leaving the air operation valve 200 as it is opened, the coolant that flowed through the bypass piping 199 is mixed with the steam via the shower head 22. As a result, a coolant of approx. 60° C flows into the first secondary coolant piping 162 on the downstream side of the shower head 22, so that the above problem does not occur. After the pressure at the pressure gauge 198 is stabilized, in other words, after the boiling is settled, the air operation valve 200 is closed to make the secondary coolant flow into the cooling water passage 36 only. Consequently, the coolant allows the shower head 22 to be lowered in temperature effectively. Note, a period until the boiling goes down is grasped previously and the valves are controlled by the valve controller 203 on a basis of the above information about the period.

Next, the second embodiment of the present invention will be described.

In this embodiment, we explain an apparatus that embodies the above-mentioned technique (referred "Sequential Flow Deposition: SFD" below) of alternately performing a process of supplying $SiH_4$-gas as the reduction gas and a process of supplying $WF_6$-gas as the film deposition gas with the via of a purging process of evacuating while supplying an inert gas between the above processes, thereby forming an initial W-film on the surface of a wafer W.

As mentioned above, although the terminology "SFD" means a technique allowing a uniform nucleation film to be formed in even a minute device hole at high step coverage, the technique is by nature a technique of making the nucleation excellent. Therefore, the element W is easy to be formed on the surface of the shower head. Further, since the processing gas is consumed by the shower head, the water-to-water reproducibility is especially deteriorated and the film deposition rate is also lowered.

As one effective countermeasure to avoid such a problem about the technique "SFD", it can be recommended to cool the shower head 22 to a temperature less than 30°C. However, when allowing the coolant to flow into the coolant passage 36 in the sidewall of the shower plate 35 in the previous embodiment of Fig. 2, the temperature of the shower plate 35 is difficult to be lowered in the vicinity of the center of the shower plate 35. In case of an apparatus corresponding to wafers of 300mm, if it is intended to cool down the center of the shower plate 35 to a temperature of 30°C, then it has to produce the coolant of - 15°C, which requires an ultra cold chiller thereby to cause a great increase in the installation cost of a system due to countermeasures of dew condensation etc. This embodiment is provided to solve such a problem.

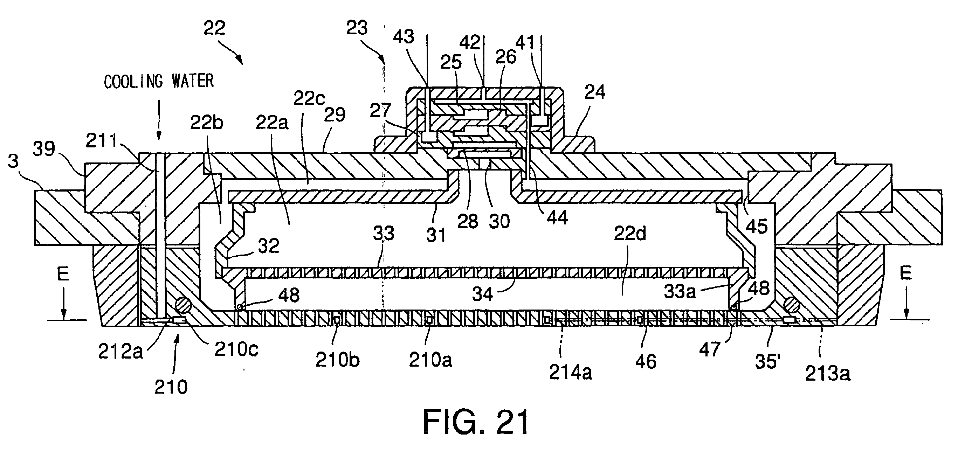

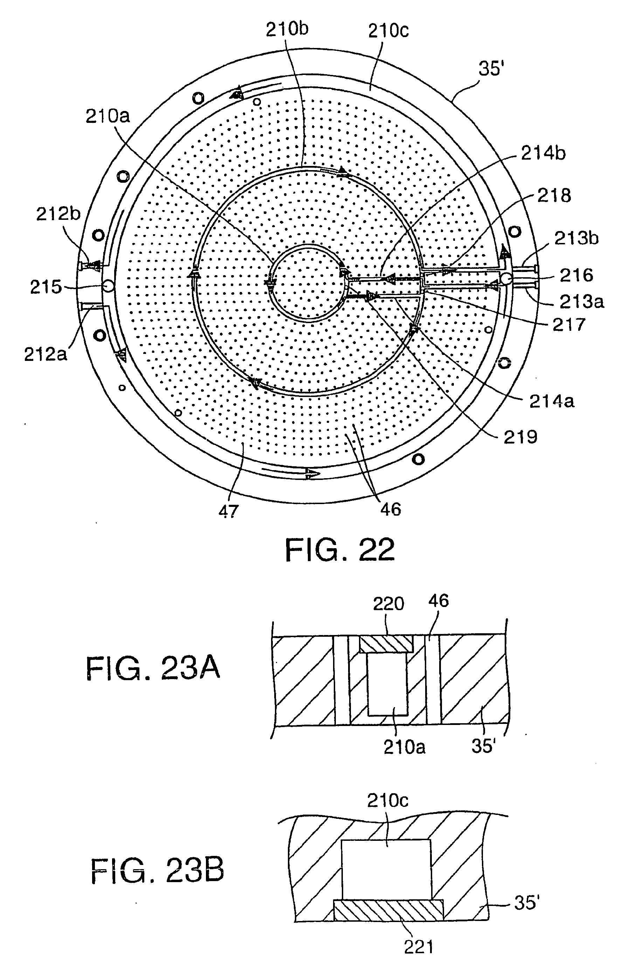

Fig. 21 is a vertical sectional view showing a shower head part of the main body of a CVD apparatus in accordance with the second embodiment of the present invention. Fig. 22 is a horizontal sectional view taken along a line E-E of Fig. 21. Basically, this apparatus is constructed similarly to the CVD apparatus in the first embodiment and differs from it in the cooling structure only. Therefore, elements identical to those of Fig. 2 are indicated with the same reference numerals respectively and their descriptions are simplified.

As shown in these figures, a shower plate 35' of this embodiment is similar to the shower plate 35 of the previous embodiment with respect to the provision of the first and second gas discharging holes 46, 47. However, the shower plate 35' differs from the shower plate 35 in a has-hole formation area where the first and second gas discharging holes 46, 47 are formed, in other words, the formation of a concentric circle-shape coolant passage 210 in a under side area of the shower plate. The cooling water is supplied to the coolant passage 210 through a coolant supply path 211 extending from a not-shown piping vertically.

The first and second gas discharging holes 46, 47 are formed radially and a plate's part interposed between these discharging holes is in the form of a concentric circle-shape. Therefore, the coolant passage 210 is shaped concentrically corresponding to the shape of the plate's part. This coolant passage 210 includes a first circular passage 210a on the innermost side from the center of the shower plate 35', a second circular passage 210b arranged outside the passage 210 and a third circular passage 210c on the outermost side, which is arranged outside the second gas discharging holes 47. Further, there are horizontally juxtaposed a coolant introducing path 212a for introducing a coolant from the coolant supply path 211 into the third circular passage 210c and a cooling water discharging path 212b for introducing a coolant from the third circular passage 210c into a not-shown coolant discharging path. On the other hand, two horizontal passages 213a, 213b in parallel are formed so as to extend from the opposite side of the coolant introducing/discharging side in the gas-hole formation area of the shower plate 35' up to the second circular passage 210b while directing the center of the shower plate 35'. Two horizontal passages 214a, 214b in parallel are formed so as to extend from respective positions deviated from the horizontal passages 213a, 213b of the second circular passage 210b slightly up to the first circular passage 210a.

In the third circular passage 210c, pins 215 and 216 are arranged between the coolant introducing path 212a and the coolant introducing path 212b and between the horizontal passage 213a and the horizontal passage 213b, respectively. Also, in the second circular passage 210b, pins 217 and 218 are arranged between the horizontal passage 213a and the horizontal passage 214a and between the horizontal passage 213b and the horizontal passage 214b, respectively. Further, in the first circular passage 21a, a pin 219 is arranged between the horizontal passage 214a and the horizontal passage 214b. Since these pins 215 to 219 are arranged so as to fill the passages, the current of the coolant is determined by these pins. That is, the cooling water supplied from the coolant introducing path 212a to the third circular passage reaches the first circular passage 210a through the horizontal passage 213a and the horizontal passage 214b and subsequently flows in the first circular passage 210a. The coolant flowing in the first circular passage 210a reaches the second circular passage 210b through the horizontal passage 214a and subsequently flows in the second circular passage 210b. The coolant flowing in the second circular passage 210b reaches the third circular passage 210c through the horizontal passage 213b and is discharged from the coolant discharging path 212b by way of the third circular passage 210c.

These passages are appropriately established corresponding to the size of the shower head 22 and the pitches of the gas discharging holes. In the shower head of this embodiment, for example, the first circular passage 210a has its center diameter of 72 mm, the second circular passage 210b has its center diameter of 216 mm, and the third circular passage 210c has its center diameter of 375. 5 mm. Further, the cross sections of the first circular passage 210a and the second circular passage 210b measure 3.3 mm in width and 6 mm in height, respectively. The cross section of the third circular passage 210c measures 11.5 mm in width and 6 mm in height. Further, the cross sections of the coolant introducing path 212a and the coolant discharging path 212b measure 7.5 mm in diameter, respectively. The cross sections of the horizontal passages 213a, 213b measure 4.5 mm in diameter, respectively. The cross sections of the horizontal passages 214a, 214b measure 3.5 mm in width and 6 mm in height, respectively.

As shown in Fig. 23A, the first circular passage 210a can be provided by the following steps of: firstly forming a ring shaped groove corresponding to the first circular passage 210a in the shower plate 35' from the upside; secondly arranging a corresponding lid 220 in the groove; and finally welding the lid 220 to the shower plate 35'. The second circular passage 210b and the horizontal passages 214a, 214b are formed in the same manner. As shown in Fig. 23B, the third circular passage 210c can be provided by the following steps of: firstly forming a annular groove corresponding to the third circular passage 210c in the shower plate 35' from the downside; secondly mounting a corresponding lid 221 in the above groove; and finally welding the lid 221 to the shower plate 35'. Further, the coolant introducing path 212a, the coolant discharging path 212b and the horizontal passages 213a, 213b are respectively provided by drilling the circumferential end of the shower plate 35'.

Next, the operation of this embodiment will be described.

First, it is performed to mount a wafer W on the mount table 5, as similar to the first embodiment. After clamping the wafer W by the clamp ring 105, a high vacuum state is formed in the processing container 2 and further, the wafer W is heated to a predetermined temperature by the lamps 86 in the heating chamber 90.

In this state, the film deposition of W-film is carried out. During the film deposition process in the processing container, it is performed to continuously supply Ar-gas as the carrier gas from the Ar-gas supply source 53 at a predetermined flow rate and also performed to continue vacuuming by the exhaust unit. Note, as the carrier gas, Ar-gas may be replaced by the other inert gas, such as $N_2$-gas and He-gas.

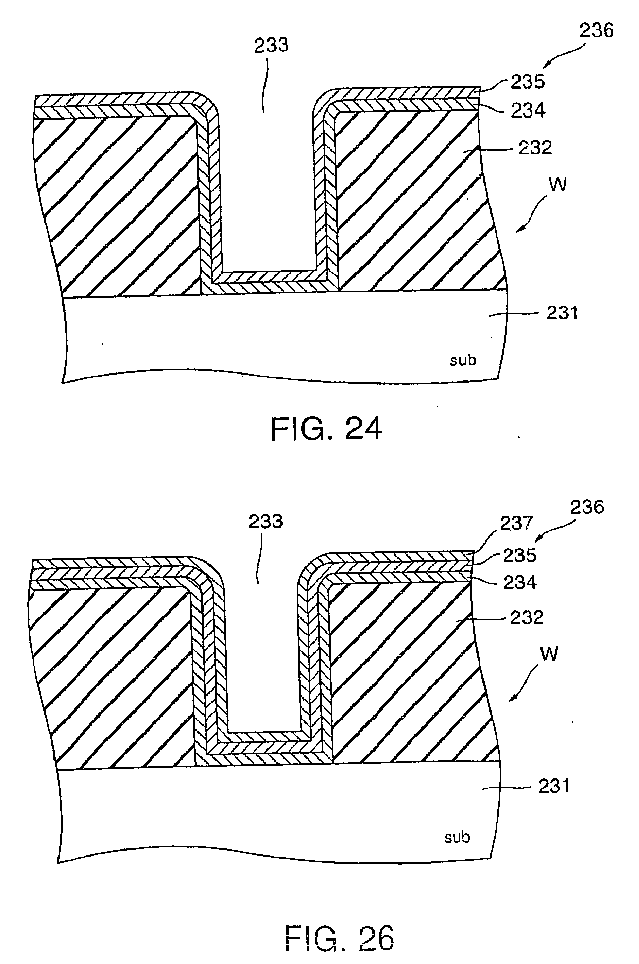

For instance, the W-film formation of this embodiment is applied to a wafer having a film structure as shown in Fig. 24. That is, on a Si-substrate 231, there is arranged an interlayer insulation film 232 having a contact hole 233 formed therein. A barrier layer 236 consisting of a Ti-film 234 and a TiN-film 235 is arranged on the interlayer insulation film 232 and also in the contact hole 233 in the film 232. According to the embodiment, a W-film is formed on the above barrier layer 236.

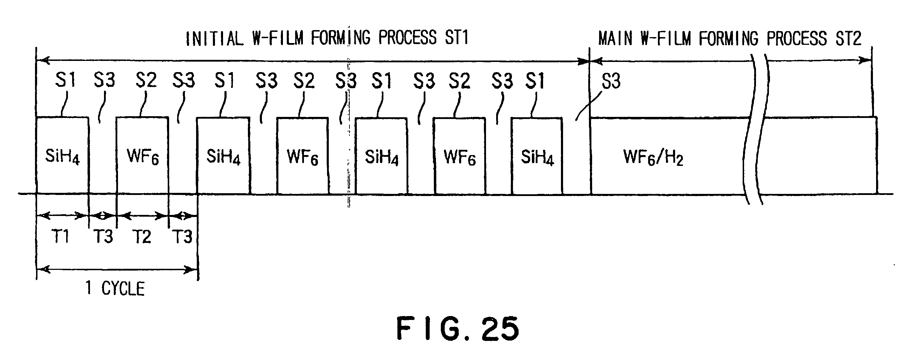

Then, the W-film formation process is carried out, for example, in accordance with a flow of Fig. 25. That is, after performing an initial W-film forming process ST1 by the technique "SFD", a main W-film forming process ST2 is carried out. In the initial W-film forming process ST1, a process of supplying $SiH_4$-gas as the reduction gas and a process of supplying $WF_6$-gas as the source gas are carried out alternately while interposing a purging process of discharging a residual gas. In detail, the $SiH_4$-gas supply process S1 is firstly performed and subsequently, the $WF_6$-gas supply process S2 is conducted via the purging process S3. These processes are repeated by several times. At the end of the initial W-film forming process ST1, both of the $SiH_4$-gas supply process S1 and the purging process S3 are carried out. By definition of a process ranging from one $SiH_4$-gas supply process S1 till a step before a start of the next-coming $SiH_4$-gas supply process S1 as one cycle, three cycles of processes are performed in this embodiment. Nevertheless, the number of repetition is not limited in particular. Alternatively, the purging process may be an operation not to make the carrier gas flowing but only performing the evacuation by an exhaust unit. As occasion demands, such a purging process may be eliminated.

In the initial W-film forming process ST1, the $SiH_4$-gas supply process S1 has supplying $SiH_4$-gas from the $SiH_4$-gas supply source 56 to the gas line 67, allowing $SiH_4$-gas to flow through the gas introducing port 41 and the first gas passage 30 in order, and discharging $SiH_4$-gas from the first discharging holes 46 of the shower head 22. The $WF_6$-gas supply process S2 has supplying $WF_6$-gas from the $WF_6$-gas supply source 52 to the gas line 62, allowing $WF_6$-gas to flow through the gas introducing port 43 and the first gas passage 30 in order, and discharging $WF_6$-gas from the first discharging holes 46 of the shower head 22. The purging process S3 between these processes has stopping the supply of $SiH_4$-gas and $WF_6$-gas, supplying Ar-gas from the Ar-gas supply source 53 to the gas line 63, allowing Ar-gas to flow through the gas introducing port 41 and the first gas passage 30 in order while discharging $SiH_4$-gas and $WF_6$-gas by the exhaust unit, and discharging Ar-gas from the first gas discharging holes 46.

In the initial W-film forming process ST1, both a period T1 of each $SiH_4$-gas supply process S1 and another period T2 of each $WF_6$-gas supply process S2 are respectively suitable to be from 1 to 30 seconds, preferably, 3 to 30 seconds. Further, a period T3 of each purging process S3 is suitable to be from 0 to 30 sec., preferably, 0 to 10 sec. Additionally, in the initial W-film forming process ST1, the flow rates of $SiH_4$-gas and $WF_6$-gas are established to be relatively small in order to reduce respective partial pressures. In detail, the flow rate of $SiH_4$-gas in each $SiH_4$-gas supply process S1 is desirable to be in a range from 0.01 to 1 L/min, more preferably, from 0.05 to 0.6 L/min. The flow rate of Ar-gas is desirable to be in a range from 0.1 to 10 L/min, more preferably, from 0.5 to 6 L/min. The flow rate of $WF_6$-gas in each $WF_6$-gas supply process S2 is desirable to be in a range from 0.001 to 1 L/min, more preferably, from 0.01 to 0.6 L/min. Further, the flow rate of Ar-gas is desirable to be in a range from 0.1 to 10 L/min, more preferably, from 0.5 to 6 L/min. The process pressure at this time is desirable to be in a range from 133 to 26600 Pa, more preferably, from 266 to 20000 Pa. As a preferable example, it can be recommended to carry out the $SiH_4$-gas supply process S1 under the following conditions of: flow ratio $SiH_4$/Ar = 0.09 / 3.9 (L/min); time T1 = 5 sec.; and process pressure = 998 Pa, and the $WF_6$-gas supply process S2 under the following conditions of: flow ratio $WF_6$/Ar = 0.03 / 3.9 (L/min); time T2 = 5 sec.; and process pressure = 998 Pa. The process temperature in this initial W-film forming process ST1 is set to a low temperature, for example, in a range from 200 to 500°C, preferably, 250 to 450°C. Further, in this initial W-film forming process ST1, it is desirable that the film thickness for one cycle is in a range from 0.1 to 5 nm, more preferably, from 0. 3 to 2 nm.

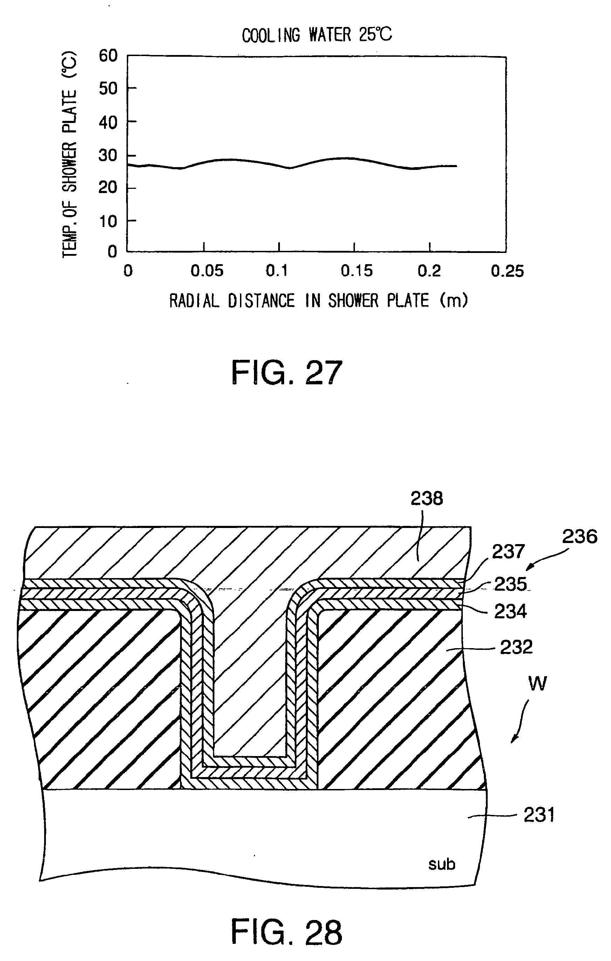

In this way, by performing the supply of $SiH_4$-gas and the supply of $WF_6$-gas alternately and repeatedly, a $SiH_4$-gas reducing reaction shown in the following formula (1) is formed, so that an initial W-film 237 functioning as the nucleation film is formed on a under barrier layer 236 uniformly at a high step coverage, as shown in Fig. 26.

$$2\,WF_6 + 3SiH_4 \rightarrow 2W + 3SiF_4 + 6H_2 \qquad (1)$$

Then, due to the alternate supply of both $SiH_4$-gas as the reduction gas and $WF_6$-gas as the W-containing gas, there is an anxiety that these gases react with each other in the shower head 22 thereby forming a film thereon. As mentioned above, however, since the concentric coolant passage 210 is formed in the gas-hole formation area of the shower plate 35', the cooling efficiency of the shower head 22 is enhanced in comparison with the previous embodiment. Thus, as the shower plate 35' can be cooled, at even a central part thereof, to be less than 30°C without using an ultra cold chiller but using coolant of normal city water, it is possible to restrict such a reaction of gases effectively. For example, if the arrangement of a coolant passage and its dimensions are those in the above-mentioned concrete example, the calculation values by use of the cooling water at 25°C are as shown in Fig. 27. From the figure, it will be understood that the arrangement of this embodiment enables any position of the shower plate 35' to be cooled below 30°C.

In the initial W-film forming process ST1, if an exhaust pathway at the $SiH_4$-gas supply process S1 is in common with that at the $WF_6$-gas supply process S2, a problem arises in that $SiH_4$-gas reacts with $WF_6$-gas in the exhaust pipe, so that a large volumn of reaction product adhere to pipes and a trap, thereby causing an increase in the frequency of maintenance. In such a case, it has only to divide the piping system into two pipelines. In connection, on the provide of a valve and an exhaust unit in each pipeline, it has only to divide the piping system into one system for the $SiH_4$-gas supply process S1 and another system for the $WF_6$-gas supply process S2 by manipulating the valves. For instance, it has only to divide the lower exhaust pipe 131 into two pipes and further provide each pipe with a valve and an exhaust unit.

After the initial W-film forming process ST1, by way of the sequent purging process S3, the main W-film forming process ST2 is performed by use of $WF_6$-gas being a W-content gas as the source gas and $H_2$-gas as the reduction gas. Then, $WF_6$-gas flows from the $WF_6$-gas supply source 52 to the gas introducing port 43 through the gas line 62 and reaches the gas introducing part 23. Main $H_2$-gas flows from the $H_2$-gas sup-

ply source 54 to the gas introducing port 41 through the gas line 65 and reaches the gas introducing part 23. Then, these gases are mixed in the gas introducing part 23. Next, the resulting mixture gas is introduced from the first gas passage 30 into the spatial part 22a of the shower head 22. Further, passing through the gas pass holes 34 in the current plate 33 and the spatial part 22, the mixture gas is discharged from the first gas discharging holes 46 through the spatial part 22d. While, the peripheral $H_2$-gas flows from the $H_2$-gas supply source 54 to the gas introducing port 42 through the gas line 64 and reaches the gas introducing part 23. Then, $H_2$-gas is introduced from the second gas passage 44 into the spatial part 22c of the shower head 22 and discharged from the second gas discharging holes 47 through the spatial part 22b. Due to the peripheral $H_2$-gas, there is no possibility that the periphery of the wafer W is short of $H_2$-gas, whereby it is possible to accomplish a uniform supply of gas. In this way, with the supply of by $WF_6$-gas and $H_2$-gas, a $H_2$ reducing reaction shown in the following formula (2) is produced on the wafer W, so that the initial W-film 237 functioning as the nucleation film is formed on a main W-film 238, as shown in Fig. 28.

$$WF_6 + 3H_2 \rightarrow W + 6HF \qquad (2)$$

A period of the main W-film forming process ST2 depends on a film thickness of a W-film to be formed. In this process, it is carried out to increase both of the flow rate of $WF_6$-gas and the flow rate of $H_2$-gas relatively and additionally, the pressure in the processing container 2 and the process temperature are slightly increased to make the film deposition rate large. Concretely, in order to obtain a step coverage and a film deposition rate more than some degrees thereof while avoiding an occurrence of volcano, the flow rate of $WF_6$-gas is desirable to be in a range from 0.001 to 1 L/min, more preferably, from 0.01 to 0.6 L/min. Further, the flow rate of $H_2$-gas is desirable to be in a range from 0.1 to 10 L/min, more preferably, from 0.5 to 6 L/min. The flow rate of Ar-gas is desirable to be in a range from 0.01 to 5 L/min, more preferably, from 0.1 to 2 L/min. The flow rate of $N_2$-gas is desirable to be in a range from 0.01 to 5 L/min, more preferably, from 0.1 to 2 L/min. The process pressure at this time is desirable to be in a range from 2660 to 26600 Pa. Further, the process temperature ranges from 300 to 500°C, preferably, 350 to 450°C. Regarding the partial gas pressure of $WF_6$-gas, a partial gas pressure exceeding 53 Pa is desirable to raise the step coverage to some degree. While, in view of avoiding an occurrence of volcano, a partial gas pressure less than 266 Pa is desirable when the process pressure in the processing container is less than 5300 Pa. Additionally, in view of enhancing a step coverage to some degree and also avoiding the occurrence of volcano, the gas ratio of $WF_6$ / $H_2$ is desirable to be in a range from 0.01 to 1, more preferably, from 0.1 to 0.5.

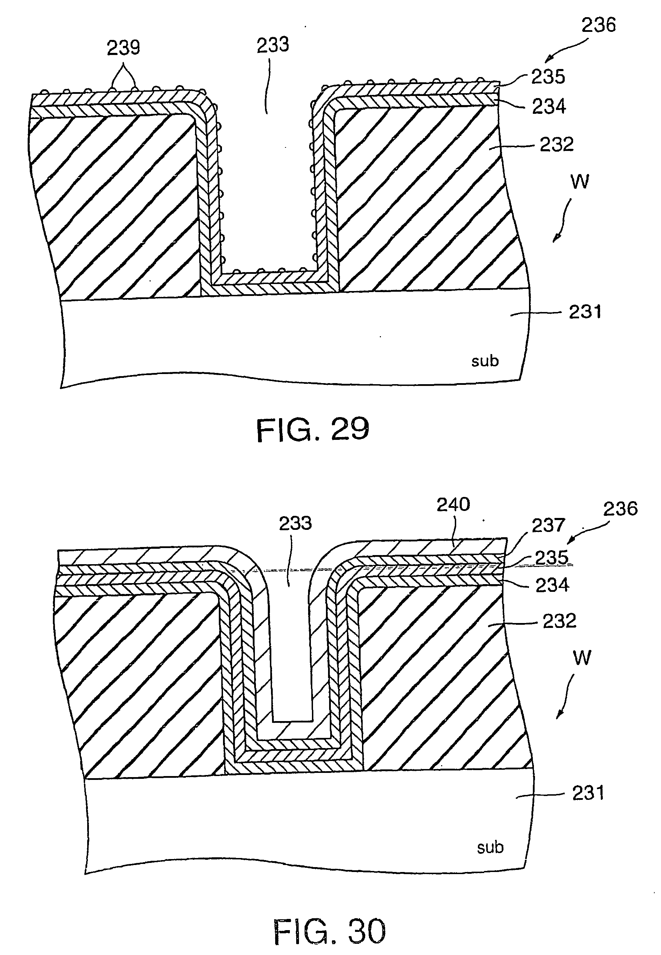

By performing the supply process of $SiH_4$-gas in place of the above initial W-film forming process ST1, the product between partial gas pressure and supply period at the former process being larger than that at the latter process, there is produced a condition similar to such a condition that the above initiation process is applied to the surface of a wafer W. As a result, as shown in Fig. 29, a reactive intermediate 239 of $SiH_X$ adheres to the surface of the barrier layer 236 on the wafer W. Accordingly, the adhesion of the reactive intermediate allows the above initial W-film 237 to be formed thereon more appropriately with respect to the uniformity in film thickness. Note, the barrier layer 236 is produced by means of the technique "CVD" or "PVD".

Additionally, by interposing a passivation W-film forming process between the initial W-film forming process ST1 and the main W-film forming process ST1, a passivation film 240 is deposited on the initial W-film 237, as shown in Fig. 30. Due to a passivation function that this passivation film possesses, the damage on the Ti-film caused by the diffusion attack of the element F of $WF_6$ in forming the main W-film 238 is prevented to make it possible to improve the embedding characteristics furthermore. Although the passivation W-film forming process employs the same gas as that in the main W-film forming process ST2, it is established that the flow ratio of $WF_6$-gas becomes smaller than that in the main W-film forming process ST2.

After completing the main W-film forming process ST2, it is carried out to stop the supply of $WF_6$-gas and further depressurize the interior of the processing container 2 by a not-shown exhaust unit quickly while maintaining the supply of Ar-gas and $H_2$-gas, thereby purging the residual processing gas remained as a result of completing the main film forming process, from the processing container 2. Next, while stopping all the supply of gases, the above depressurizing operation is maintained to form a high vacuum in the processing container 2. Thereafter, it is carried out to raise the lift pins 12 and the clamp ring 10 thereby raising the wafer W up to a position where the transfer arm receives the wafer W on the lift pins 12. Further, the transfer arm takes the wafer W out of the processing container 2, whereby the film deposition operation is ended. After taking out the wafer W, as occasion demands, the interior of the processing container 2 is cleaned by feeding $ClF_3$-gas from the $ClF_3$-gas source 61 into the processing container 2. Further, if necessary, the above-mentioned flashing process may be performed.

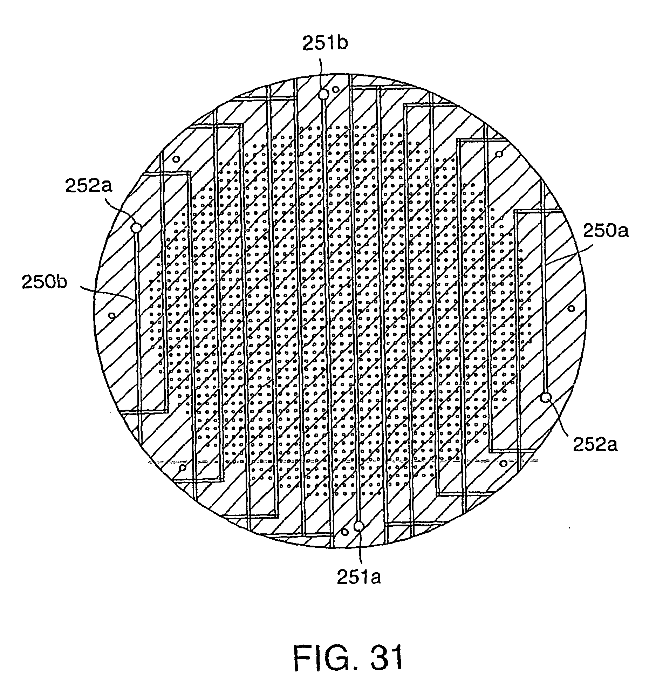

It is noted that, unlimitedly to three paths only, the number of the coolant passages may be more or less than three. Since the is formed corresponding to the shaped of a portion interposed between a plurality of gas discharging holes, the coolant path is not necessarily shaped to be concentric. For example, if the gas discharging holes 46 are arranged in a lattice pattern, as shown in Fig. 31, there may be formed coolant passages 250a, 250b in the form of straight passages because respective portions among the gas discharging holes 46 are also shaped in a lattice pattern. In the modification, the coolant passage may be formed in a "zigzag" pattern, spiral pattern or the other pattern. Note, reference numerals 251a, 251b designate coolant introducing parts, while numerals 252a, 252b designate coolant discharging parts, respectively. Further, the coolant passage of this embodiment is not limited to that in the above "SFD" case. Thus, the coolant passage of this embodiment is applicable that in the normal film deposition process and also adoptable for the apparatus in the previous embodiment.

Next, the third embodiment of the present invention will be described.

This embodiment also relates to an apparatus for carrying out the technique "SFD" in the initial W-film forming process. In this embodiment, however, the supply pathway of $SiH_4$-gas and $WF_6$-gas in the initial W-film forming process is divided into respective pathways in order to suppress a reaction between these gases in the shower head.

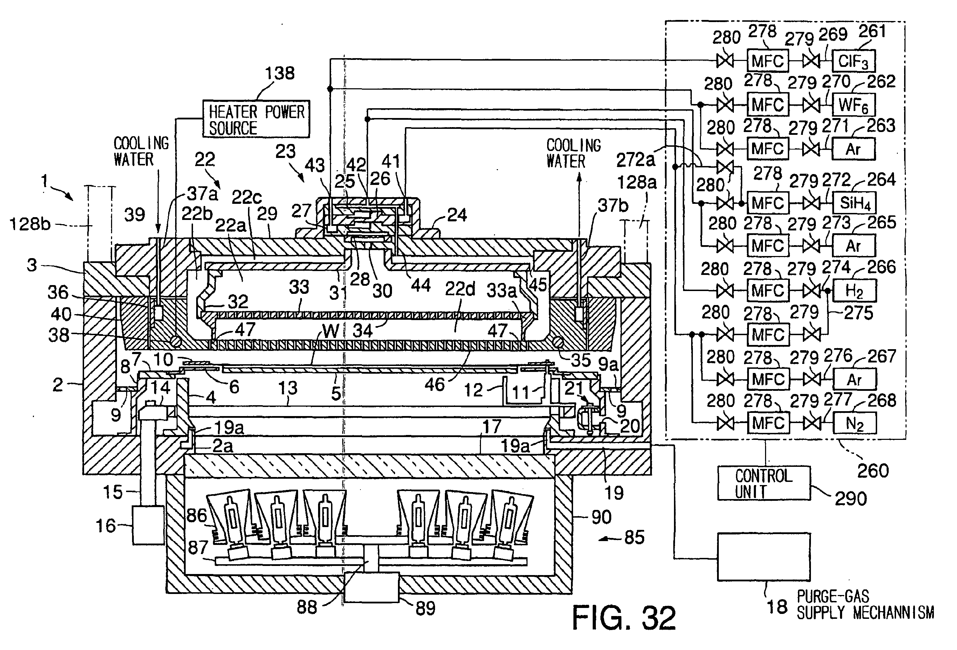

Fig. 32 is a sectional view showing the main body of a CVD apparatus of this embodiment. Basically, this apparatus is constructed similarly to the CVD apparatus of Fig. 2 in the first embodiment and is different from it in its gas supply mechanism only. Therefore, elements identical to those of Fig. 2 are respectively indicated with the same reference numerals to simplify the explanation.

A gas supply mechanism 260 includes a $ClF_3$-gas supply source 261 for supplying $ClF_3$-gas as the cleaning gas, a $WF_6$-gas supply source 262 for supplying $WF_6$-gas being a W-containing gas as the deposition material, a first Ar-gas supply source 263 for supplying Ar as the carrier gas and the purge gas, a $SiH_4$-gas supply source 264 for supplying $SiH_4$-gas as the reduction gas, a second Ar-gas supply source 265, a $H_2$-gas supply source 266 for supplying $H_2$-gas as the reduction gas, a third Ar-gas supply source 267 and a $N_2$-gas supply source 268.

A gas line 269 is connected to the $ClF_3$-gas supply source 261, a gas line 270 being connected to the $WF_6$-gas supply source 262, and a gas line 271 is connected to the first Ar-gas supply source 263. These gas lines 269, 270 are connected to the gas introducing port 43 of the gas introducing part 23. The gas line 271 from the first Ar-gas supply source 263 is connected to the gas line 270. Respective gases from these gas supply sources 261, 262, 263 do flow from the gas introducing port 43 to given pathways in the gas introducing part 23 and successively flow from the first gas passage 30 into the spatial part 22a. Further, passing through the gas discharging holes 34 of the current plate 33 and reaching the spatial part 22d, these gases are discharged from the first gas discharging holes 46.

A gas line 272 is connected to the $SiH_4$-gas supply source 264, while a gas line 273 is connected to the second Ar-gas supply source 265. The gas line 272 is connected to the gas introducing port 43 of the gas introducing part 23. A blanch line 272a blanching from the gas line 272 is connected to the gas line 275 and further connected to the gas introducing port 41 through the gas line 275. Additionally, a gas line 273 from the second Ar-gas supply source 265 is connected to the gas line 272. Respective gases from these gas supply sources 264, 265 are introduced into the spatial part 22c through the second gas passage 44. Further, passing through the spatial part 22b, these gases are discharged from the second gas discharging holes 47.

Both of gas lines 274 and 275 are connected to the $H_2$-gas supply source 266, while a gas line 276 is connected to the third Ar-gas supply source 267. Further, a gas line 277 is connected to the $N_2$-gas supply source 268. The gas line 274 is connected to the above gas introducing port 42, the gas line 275 being connected to the gas introducing port 41 of the gas introducing part 23, and both of the gas line 276 from the third Ar-gas supply source 267 and the gas line 277 from the $N_2$-gas supply source 268 are connected to the gas line 275. Respective gases from these gas supply sources 266, 267, 268 do flow from the gas introducing port 41 to designated routes in the gas introducing part 23 and successively flow from the first gas passage 30 into the spatial part 22a. Further, passing through the gas discharging holes 34 of the current plate 33 and reaching the spatial part 22d, these gases are discharged from the first gas discharging holes 46. On the other hand, $H_2$-gas that has been supplied to the gas introducing part 42 through the gas line 274 is discharged from the second gas discharging holes 47 formed in the outer peripheral part of the shower plate 35, allowing $H_2$-gas in the periphery of the wafer to be supplemented in forming the main W-film.

Note, in these gas lines 269, 270, 271, 272, 273, 274, 275, 276 and 277, there are provided a mass-flow controller 278 and closing valves 279, 280 in front and behind, for each line. Note, in the gas supply mechanism 260, the gas supply using the valves etc. is controlled by a control unit 290.

Next, the operation of this embodiment will be described.

First, it is performed to mount a wafer W on the mount table 5, as similar to the second embodiment. After claming the wafer W by the clamp ring 10, a high vacuum state is formed in the processing container 2 and further, the wafer W is heated to a predetermined temperature by the lamps 86 in the heating chamber 90.

During the film deposition process, as similar to the first and second embodiments, it is performed to continuously supply Ar-gas as the carrier gas from the Ar-gas supply source 53 at a predetermined flow rate and also performed to continue the formation of a vacuum by the exhaust unit. Note, as the carrier gas, Ar-gas may be replaced by the other inert gas, such as $N_2$-gas and He-gas.

Similarly to the second embodiment, according to this embodiment, the W-film formation is performed for a wafer having a film structure shown in e.g. Fig. 24, in accordance with e.g. a flow of Fig. 25. That is, after performing the initial W-film forming process ST1 by means of the technique "SFD", the main W-film forming process ST2 is carried out. Note, similarly to the second embodiment, the repetition number of the initial W-film forming process ST1 is not limited in particular. Additionally, the purging process may be accomplished by only allowing the exhaust unit to evacuate without supplying the carrier gas. Alternatively, as occasion demands, such a purging process may be eliminated.

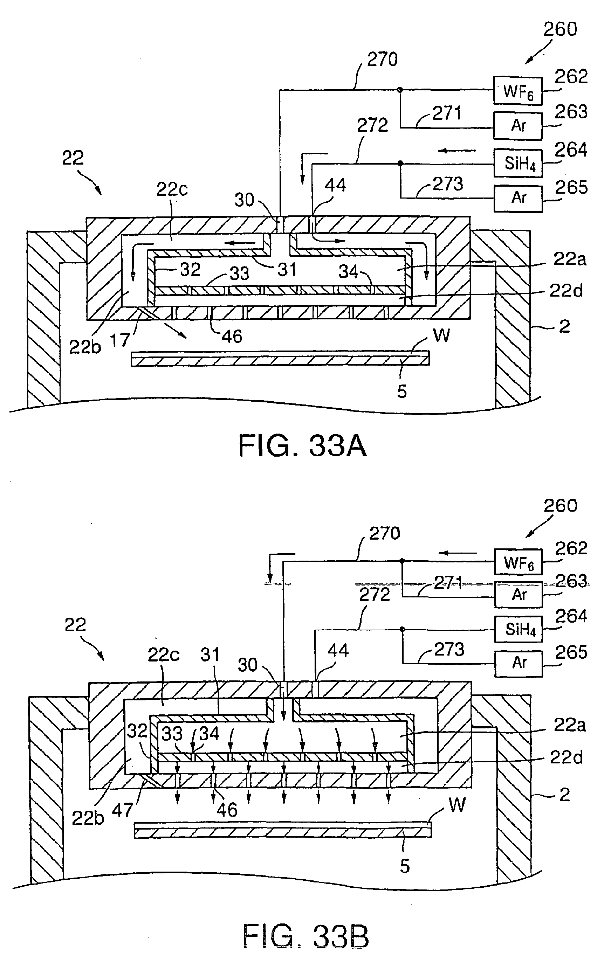

In the initial W-film forming process ST1, as typically shown in Fig. 33A, the $SiH_4$-gas supply process S1 is accomplished by the following flow of $SiH_4$-gas from the $SiH_4$-gas supply source 264 to the second discharging holes 47 in the periphery part of the shower head 22 via the gas line 272, the second gas passage 44, the spatial part 22c of the shower head 22 and the spatial part 22b, in order. Then, $SiH_4$-gas is discharged from the second discharging holes 47. Note, $SiH_4$-gas is carried by Ar-gas supplied from the second Ar-gas supply source 265 via the gas line 273. While, as typically shown in Fig. 33B, the $WF_6$-gas supply process S2 is accomplished by the following flow of $WF_6$-gas from the $WF_6$-gas supply source 262 to the first discharging holes 46 via the gas line 270, the first gas passage 30, the spatial part 22a of the shower head 22, the gas pass holes 34 in the current plate 33, and the spatial part 22d, in order. Then, $WF_6$-gas is discharged from the first discharging holes 46. Note, $WF_6$-gas is carried by Ar-gas supplied from the first Ar-gas supply source 263 via the gas line 271. The purging process S3 performed between these processes is to stop the supply of $SiH_4$-gas and $WF_6$-gas and further supply Ar-gas while exhausting by the exhaust unit. Note, for convenience of understanding, the gas introducing part 23 is eliminated in Figs. 33A and 33B.

In the above way, although this embodiment differs from the second embodiment with respect to the pathway of $SiH_4$-gas in the initial W-film forming process ST1, the former is similar to the latter in terms of the other conditions, such as flow rate of gases and supplying period thereof.

Also in this embodiment, by performing the supply of $SiH_4$-gas and the supply of $WF_6$-gas alternately and repeatedly, the $SiH_4$-gas reducing reaction shown in the following formula (1) is generated. Consequently, as shown in Fig. 26, the initial W-film 237 functioning as the nucleation film is formed on the under barrier layer 236 uniformly, at a high step coverage. For instance, even if the aspect ratio of hole is more than five, more preferably, ten, a uniform film can be produced at a high step coverage.

In supplying $SiH_4$-gas as the reduction gas and $WF_6$-gas as the W-containing gas alternately thereby forming an initial W-film, since $SiH_4$-gas and $WF_6$-gas

are respectively supplied through the intermediary of different gas routes separated from each other in the shower head 22, there is no contact between $SiH_4$-gas and $WF_6$-gas in the shower head 22. Therefore, without cooling down the shower head 22 to a temperature below 30°C and with the normal cooling, it is possible to prevent an undesired W-film from being formed in the shower head 22.

Note, the main W-film forming process ST2 succeeding to the initial W-film forming process ST1 is carried out in the same manner as the most recently mentioned embodiment while using $WF_6$-gas as the W-containing gas being a source gas and $SiH_4$-gas as the reduction gas.

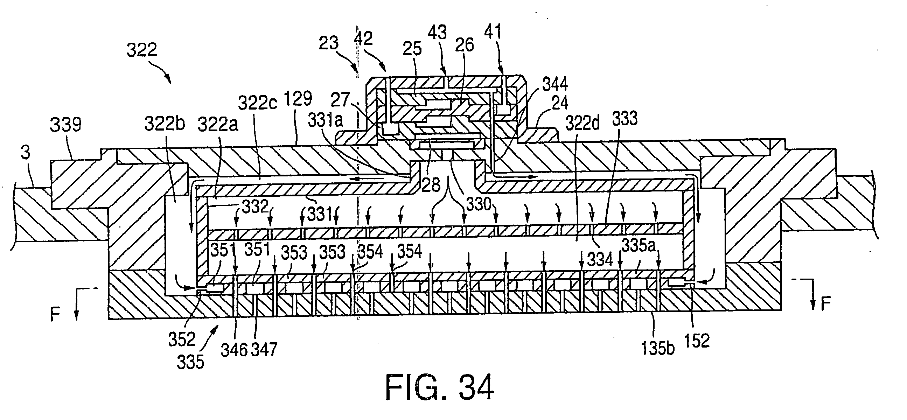

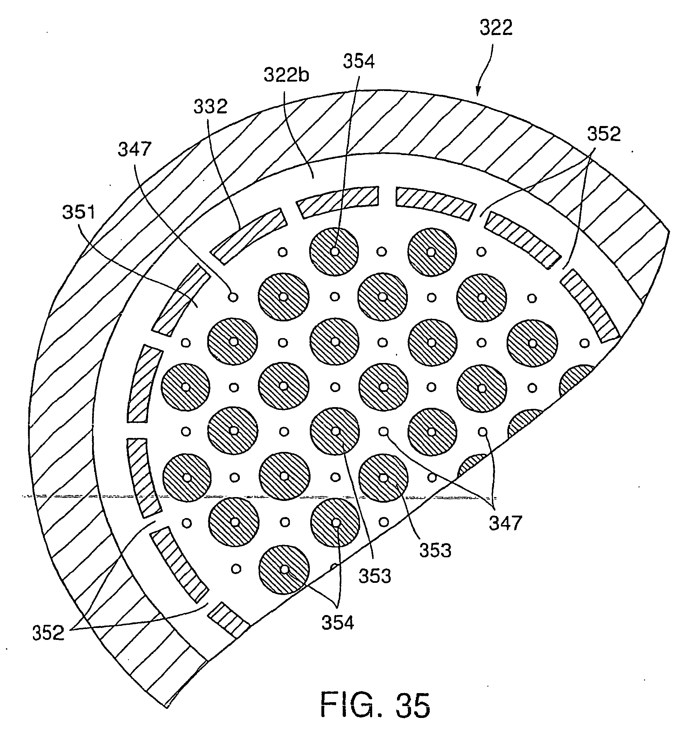

Next, we describe another example of the shower head that allows $SiH_4$-gas and $WF_6$-gas to be supplied through the gas routes separated from each other in the shower head 22 in the initial W-film forming process ST1. Fig. 34 is a schematic sectional view showing another example of the shower head of this embodiment and Fig. 35 is a horizontal sectional view taken along a line F-F of Fig. 34. In Figs.34 and 35, elements identical to those in Fig. 32 are indicated with the same reference numerals, so that their explanations are simplified.

A shower head 322 includes a cylindrical shower base 339 whose outer periphery is formed so as to fit the upper part of the lid 3, a disk-shaped introducing plate 329 arranged so as to cover the upper part of the shower base 339 and also provided, at the top center, with the gas introducing part 23, and a shower plate 335 attached to the lower part of the shower base 339.

The above gas introducing plate 329 is provided, at a center thereof, with a first gas introducing hole 330 for introducing a predetermined gas into the shower head 322 through the gas introducing part 23. Around the first gas introducing hole 330, a plurality of second gas passages 344 are formed to introduce a different gas from the above in charge of the first gas passage into the shower head 122 through the gas introducing part 23.

In the interior space of the shower head 322 surrounded by the shower base 339, the gas introducing plate 329 and the shower plate 335, a horizontal partition 331 in the form of a substantial circular ring is positioned just below the gas introducing plate 329 horizontally. In the inner circumferential part of the horizontal partition 331, a cylindrical projecting part 331a is formed so as to gibbosite upwardly. This cylindrical gibbosity part 331a is connected to the gas introducing plate 329.

A cylindrical vertical partition 332 is arranged between the outer periphery of the horizontal partition 331 and the shower plate 335. In the interior space of the partition 332, a current plate 333 is arranged above the shower plate 335 while positioning the plate's surface horizontally. This shower plate 335 is formed with a plurality of gas pass holes 334.

Therefore, the inside space of the shower head 322 is partitioned by a spatial part 322a between the horizontal partition 331 and the current plate 333, a spatial part 322c between the gas introducing plate 329 and the horizontal partition 331, an annular spatial part 322 between the shower base 339 and the vertical partition 331 and a spatial part 322d between the current plate 333 and the shower plate 335. In these parts, the spatial part 322b is communicated with the spatial part 322c. Further, the first gas itroducing hole 330 of the gas introducing plate 329 is communicated with the spatial part 322a, while the second gas passage 344 is communicated with the spatial part 322c. However, the spatial part 322c is secluded from the spatial part 322a by the horizontal partition 331 and the gibbosity part 331a. Again, the spatial part 322b is secluded from the spatial part 322a and also the spatial part 322d by the vertical partition 332, respectively.

The above shower plate 335 is provided with a vertical double-layer structure consisting of an upper plate 335a and a lower plate 335b. As shown in Fig. 35, a spatial part 351 is formed in the upper plate 335 throughout while leaving a plurality of column parts 353 vertically. The vertical partition 332 is formed with a plurality of communication paths 352 through which the spatial part 322b communicates with the spatial part 351. The plural column parts 353 are provided, at respective centers thereof and vertically, with gas flow holes 354 respectively. The gas flow holes 354 are adapted so as to lead a gas that has reached the spatial part 322d, downwadly. In the lower plate 335b, a plurality of first gas discharging holes 346 and a plurality of second gas discharging holes 347 are formed vertically and also in a matrix pattern. The plural first gas discharging holes 346 communicate with the plural gas flow holes 354 of the upper plate 335a, respectively. While, the plural second gas discharging holes 347 are arranged in correspondence positions in the spatial part 351. Then, gas introduced from the first gas introducing hole 330 passes through the spatial part 322a, the gas pass holes 334, the spatial part 322d and the gas flow holes 354 in order and is discharged from the first gas discharging holes 346. While, gas introduced from the second gas passages 344 reaches the spatial part 351 by way of the spatial parts 322c, 322 and the communication path 352, in order and is discharged from the second gas discharging holes 347. Therefore, the shower head 322 constitutes a "matrix" shower that is equipped with the first and second gas discharging holes 346 and 347 each discharging gases by way of different gas supply pathways apart from each other, the pathways comprising: a first gas supply pathway composed of the first gas passage 330, the spatial part 322a, the gas pass holes 334 and the spatial part 322d; and a second gas supply route composed of the second gas passages 344, the spatial parts 322c, 322d and the annular spatial part 351.

Also in the so-constructed shower head, since it allows $WF_6$-gas as the W-containing gas to be discharged from the first gas discharging holes 346 through the first gas supply pathway and $SiH_4$-gas as the reduction gas to be discharged from the second gas discharging holes 347 through the second gas supply pathway perfectly separated from the first gas supply pathway, it is possible to prevent these gases from being reacted to each other in the shower head 322, whereby the adhesion of an undesired W-film to the interior of the shower head 322 can be prevented. Additionally, the matrix shower like this enables $SiH_4$-gas to be supplied into the processing container 2 uniformly since the same gas flows through the spatial part 322b and the communication path 352 and is diffused into the spatial part 351.

Note, in this embodiment, since $SiH_4$-gas as the reduction gas and $WF_6$-gas as the W-containing gas are discharged under their mutually-isolated conditions due to the different supply pathways, there is no need to always make the temperature of the shower head less than 30°C. In view of preventing reaction by-product materials containing $TiF_X$ from adhering to the shower head, the above temperature may be more than 80°C, preferably, more than 100°C. Alternatively, if making the temperature of the shower plate less than 30°C by use of the shower plate of Figs. 21, 22, which is equipped with the coolant passages in the gas-hole formation area, then it becomes possible to prevent film deposition onto the shower head certainly. Noted again, although $SiH_4$-gas as the reduction gas is used in forming the initial W-film, unlimitedly to this gas, there may be employed at least one kind of $H_2$-gas, $SiH_4$-gas, $Si_2H_6$-gas, $SiCl_4$-gas, $SiH_2Cl_2$-gas, $SiHCl_3$-gas, $B_2H_6$-gas and $PH_4$-gas. Further, without being limited to $WF_6$-gas only, an organic W-containing gas may be employed as the W-containing gas. Furthermore, we have described the structure of a shower head by examples of one structure having the gas passage for the central part of the shower head and the gas passage for the peripheral part and another "matrix" structure: nevertheless the structure of the shower head is not limited to these structures only.

Without being limited to the above-mentioned embodiments, the present invention may be modified variously. For example, although the second gas discharging holes 47 are formed vertically and inclined inwardly in the above embodiments, they may be inclined outwardly. Additionally, although the present invention is applied to the CVD film deposition of W in the above embodiments, not limited to this application, the present invention is also applicable to the CVD film deposition of Ti etc. that employs $H_2$-gas as similar to the film deposition of W. Further, the present invention is also applicable to an etching process. Still further, the present invention can exhibit superior effects in the application to a gas processing using gas having a high diffusion velocity, such as $H_2$-gas, and gas having a low diffusion velocity, such as $WF_6$. However, unlimitedly to this application only, even when processing an object with use of a single gas or if there is no great difference in diffusion velocity between gases on use, it is possible to prevent a reduction of gas concentration on the peripheral side of a wafer W owing to the application of the present invention. Moreover, it should be note that, unlimitedly to a wafer only, an object to be processed by the invention may be one of the other substrates.

As mentioned above, according to the present invention, the processing-gas discharging mechanism includes the first gas discharging part provided corresponding to a substrate to be processed mounted in the mount table and the second gas discharging part arranged around the first gas discharging part independently to discharge the processing gas into the circumference of the substrate to be processed mounted on the mount table. Accordingly, by discharging the processing gas through the first gas discharging part and further discharging the processing gas from the second gas discharging part, it is possible to prevent the concentration of the processing gas from being lowered in the circumference of the substrate to be processed, accomplishing the application of a "uniform" gas processing in a plane to of the substrate to be processed.

Further, according to the present invention, since the gap layer is formed between the gas discharging part and the base part to function as a heat insulating layer, it is possible to suppress heat dispersion from the heater of the gas discharging part, allowing the gas discharging part to be heated with high efficiency.

Still further, according to the present invention, as the gas discharging part is fastened to the base part so as to allow a relative displacement therebetween, even if the gas discharging part is heated by the heater and expanded thermally, there is produced almost no strain in the gas discharging part and also in the base part due to the relative displacement between the gas discharging part and the base part, whereby it is possible to reduce the influence of thermal expansion on the gas discharging part.

According to the present invention, in the apparatus to supply the first processing gas and the second processing gas, which are required to keep the temperature of the gas discharging part of the gas discharging mechanism low, the coolant passage is arranged in the gas discharging plate's area where the gas discharging holes are formed. Therefore, even if the gas discharging mechanism is large-sized with the large-sized substrate to be processed, it becomes possible to effectively cool the gas discharging part to a desired temperature without using any special installation, such as ultra cold chiller and with a normal coolant, such as cooling water.

Further, according to the present invention, when alternately supplying the first processing gas and the second processing gas in order to form a film, the processing container is supplied with the first processing gas and the second processing gas through the gas supply pathways separated from each other in the gas discharging member. Therefore, as the first processing gas does not come into contact with the second processing gas in the gas discharging member, it becomes possible to prevent deposition of undesired film in the gas discharging member without any special cooling.

**Claims**

1.   A gas processing apparatus comprising:

a processing container for housing a substrate to be processed;
a mount table arranged in the processing container to mount the substrate to be processed thereon;
a processing-gas discharging mechanism arranged in a position opposing the substrate to be processed mounted on the mount table to discharge a processing gas into the processing container; and
exhausting means for exhausting an interior of the processing container, wherein the processing-gas discharging mechanism includes
a first gas discharging part provided corresponding to the substrate to be processed mounted in the mount table; and
a second gas discharging part arranged around the first gas discharging part independently to discharge the processing gas into the periphery of the substrate to be processed mounted on the mount table.

2.   A gas processing apparatus for applying a gas processing to a substrate to be processed while using a gas containing a first processing gas of a relatively high diffusion velocity and a second processing gas of a relatively low diffusion velocity, the gas processing apparatus comprising:

a processing container for housing a substrate to be processed;
a mount table arranged in the processing container to mount the substrate to be processed thereon;
a processing-gas discharging mechanism arranged in a position opposing the substrate to be processed mounted on the mount table to discharge a gas containing the first processing gas and the second processing gas into the processing container; and
exhausting means for exhausting an interior of the processing container, wherein the processing-gas discharging mechanism includes
a first gas discharging part provided corresponding to the substrate to be processed mounted in the mount table to discharge the gas containing the first processing gas and the second processing gas; and
a second gas discharging part arranged around the first gas discharging part independently, to discharge the first processing gas into the circumference of the substrate to be processed mounted on the mount table.

3. A gas processing apparatus comprising:

   a processing container for housing a substrate to be processed;
   a mount table arranged in the processing container to mount the substrate to be processed thereon;
   a processing-gas discharging mechanism arranged in a position opposing the substrate to be processed mounted on the mount table to discharge a processing gas containing $H_2$-gas and $WF_6$-gas into the processing container; and
   exhausting means for exhausting an interior of the processing container, wherein the processing-gas discharging mechanism includes
   a first gas discharging part provided corresponding to the substrate to be processed mounted in the mount table to discharge the processing gas containing $H_2$-gas and $WF_6$-gas; and
   a second gas discharging part arranged around the first gas discharging part independently, to discharge $H_2$-gas into the periphery of the substrate to be processed mounted on the mount table.

4. A gas processing apparatus as claimed in any one of Claim 1 to Claim 3, wherein the processing-gas discharging mechanism includes the gas discharging plate having a first gas discharging part and the second gas discharging part, and the first gas discharging part and the second discharging part each have a plurality of gas discharging holes formed in the gas discharging plate.

5. A gas processing apparatus as claimed in any one of Claim 1 to Claim 4, further comprising:

   a coolant passage arranged in the processing-gas discharging mechanism;
   a coolant flow piping arranged both in upstream of the coolant passage and in the downstream;
   a bypass piping connected, both in upstream of the processing-gas discharging mechanism and in the downstream, to the coolant flow piping while bypassing the processing-gas discharging mechanism;
   a pressure relief valve arranged on the downstream side of the coolant passage in the coolant flow piping;
a group of valves defining a flowing pathway of the coolant;
control means for controlling the group of valves; and
a heater for heating the processing-gas discharging mechanism, wherein
when cooling the processing-gas discharging mechanism, the control means controls the group of valves so as to allow the coolant to flow into the coolant passage,
when heating the processing-gas discharging mechanism, the control means operates the heater and further controls the group of valves so as to stop the inflow of the coolant into the coolant passage and allow the coolant to flow into the bypass piping, and
when lowering a temperature of the processing-gas discharging mechanism in its elevated condition in temperature, the control means controls the group of valves so as to allow the coolant to flow into both of the coolant passage and the bypass piping.

6. A gas processing apparatus as claimed in Claim 4, wherein the processing-gas discharging mechanism has a coolant passage.

7. A gas processing apparatus as claimed in Claim 6, wherein the coolant passage is arranged in an area of the gas discharging plate where the gas discharging holes are formed.

8. A gas processing apparatus as claimed in Claim 7, wherein the coolant passage is formed so as to correspond to the shape of a gas discharging plate's part interposed among the plural gas discharging holes in the gas discharging plate's area where the gas discharging holes are formed.

9. A gas processing apparatus as claimed in Claim 8, wherein the coolant passage is formed concentrically.

10. A gas processing apparatus as claimed in any one of Claim 4 and Claims 6 to 9, wherein the processing-gas discharging mechanism has a heater.

11. A gas processing apparatus as claimed in any one of Claims 4 to 10, wherein the plural gas discharging holes included in the second gas discharging part are arranged outside the periphery of the substrate to be processed on the mount table.

12. A gas processing apparatus as claimed in any one of Claims 4 to 11, wherein the plural gas discharging holes included in the second gas discharging part are arranged perpendicularly to the substrate to be processed on the mount table.

13. A gas processing apparatus as claimed in any one of Claims 4 to 12, wherein the plural gas discharging holes included in the second gas discharging part are arranged in the periphery of the first gas discharging part, in one or more lines.

14. A gas processing apparatus as claimed in Claim 13, wherein the plural gas discharging holes included in the second gas discharging part form a first line and a second line, both of which are concentric to each other, in the periphery of the first gas discharging part, and the gas discharging holes forming the first line and the gas discharging holes forming the second line are arranged alternately.

15. A gas processing apparatus as claimed in any one of Claims 1 to 14, wherein the exhausting means carries out exhaust from the peripheral side of the substrate to be processed on the mount table.

16. A gas processing apparatus as claimed in Claim 15, further comprising an annular baffle plate having a plurality of exhaust holes, wherein the exhausting means exhausts the interior of the processing container through the exhaust holes.

17. A gas processing method for applying a gas processing to a substrate to be processed in a processing container while supplying a processing gas to the substrate, the gas processing method comprising the steps of:

discharging the processing gas through a first gas discharging part provided so as to oppose the substrate to be processed; and discharging the processing gas to the periphery of the substrate to be processed through a second gas discharging part provided around the first gas discharging part independently, thereby performing the gas processing.

18. A gas processing method for applying a gas processing to a substrate to be processed while supplying the substrate in a processing container with a gas containing a first processing gas of a relatively high diffusion velocity and a second processing gas of a relatively low diffusion velocity, the gas processing method comprising the steps of:

discharging a gas containing the first processing gas and the second processing gas from a first gas discharging part that is arranged so as to oppose the substrate to be processed, and further discharging the first processing gas to the periphery of the substrate from a second gas discharging part that is arranged around the first gas discharging part independently, thereby performing the gas processing.

19. A gas processing method for applying a gas processing to form a W-film on a substrate to be processed while supplying the substrate to be processed in a processing container with a processing gas containing $H_2$-gas and $WF_6$-gas, the gas processing method comprising the steps of:

discharging a processing gas containing $H_2$-gas and $WF_6$-gas from a first gas discharging part that is arranged so as to oppose the substrate to be processed, and further discharging $H_2$-gas to the periphery of the substrate from a second gas discharging part that is arranged around the first gas discharging part independently, thereby forming the W-film on the substrate to be processed.

20. A gas processing method as claimed in any one of Claims 17 to 19, further comprising the step of carrying out exhaust from the peripheral side of the substrate to be processed, at the gas processing.

21. A gas processing apparatus comprising:

a processing container for housing a substrate to be processed;
a mount table arranged in the processing container to mount the substrate to be processed thereon;
a processing-gas discharging mechanism arranged in a position opposing the substrate to be processed mounted on the mount table to discharge a processing gas into the processing container; and
exhausting means for exhausting an interior of the processing container, wherein the processing-gas discharging mechanism includes
a gas discharging part having a discharging hole for discharging the processing gas;
a base part supporting the gas discharging part;
a heater provided in the gas discharging part; and
a gap layer defined between the gas discharging part and the base part.

22. A gas processing apparatus comprising:

a processing container for housing a substrate to be processed;
a mount table arranged in the processing container to mount the substrate to be processed thereon;
a processing-gas discharging mechanism arranged in a position opposing the substrate to be processed mounted on the mount table to discharge a processing gas into the processing container; and

exhausting means for exhausting an interior of the processing container, wherein the processing-gas discharging mechanism includes

a gas discharging part having a discharging hole for discharging the processing gas;

a base part supporting the gas discharging part;

a heater provided in the gas discharging part; and

a fastening mechanism for fastening the gas discharging part to the base part so as to allow a relative displacement therebetween.

23. A gas processing apparatus as claimed in Claim 22, wherein the fastening mechanism includes a fixing part for holding the gas discharging part to the base part and a moving part arranged on the opposite side of the holding part to allow a relative displacement between the gas discharging part and the base part.

24. A gas processing apparatus comprising:

a processing container for housing a substrate to be processed;

a mount table arranged in the processing container to mount the substrate to be processed thereon;

first processing-gas supplying means for supplying a first processing gas into the processing container;

second processing-gas supplying means for supplying a second processing gas into the processing container;

a processing-gas discharging mechanism arranged in a position opposing the substrate to be processed mounted on the mount table to discharge the first processing gas and the second processing gas supplied from the first and second processing-gas supplying means respectively, into the processing container; and

exhausting means for exhausting an interior of the processing container, the gas processing apparatus supplying the first processing gas and the second processing gas alternately to react these gases on the substrate to be processed thereby forming a desired film thereon, wherein

the processing-gas discharging mechanism includes a gas discharging plate having a plurality of gas discharging holes for discharging the first and second processing gases, and a coolant passage, and

the coolant passage is arranged in a gas discharging plate's area where the gas discharging holes are formed.

25. A gas processing apparatus as claimed in Claim 24, wherein the coolant passage is formed so as to correspond to the shape of a gas discharging plate's part interposed among the plural gas discharging holes in the gas discharging plate's area where the gas discharging holes are formed.

26. A gas processing apparatus as claimed in Claim 25, wherein the coolant passage is formed concentrically.

27. A gas processing apparatus as claimed in any one of Claims 24 to 26, wherein the processing-gas discharging mechanism has a heater.

28. A gas processing apparatus as claimed in Claim 27, further comprising:

a coolant flow piping arranged both in upstream of the coolant passage and in the downstream;

a bypass piping connected, both in upstream of the processing-gas discharging mechanism and in the downstream, to the coolant flow piping while bypassing the processing-gas discharging mechanism;

a pressure relief valve arranged on the downstream side of the coolant passage in the coolant flow piping;

a group of valves defining a flowing route of the coolant;

control means for controlling the group of valves; and

a heater for heating the processing-gas discharging mechanism, wherein

when cooling the processing-gas discharging mechanism, the control means controls the group of valves so as to allow the coolant to flow into the coolant passage,

when heating the processing-gas discharging mechanism, the control means operates the heater and further controls the group of valves so as to stop the inflow of the coolant into the coolant passage and allow the coolant to flow into the bypass piping, and

when lowering a temperature of the processing-gas discharging mechanism in its elevated condition in temperature, the control means controls the valves so as to allow the coolant to flow into both of the coolant passage and the bypass piping.

29. A gas processing method for alternately supplying a first processing gas and a second processing gas to a substrate to be processed in a processing container through a gas discharging member to allow these gases to react on the substrate to be processed thereby forming a designated film thereon, the gas processing method comprising the step of:

supplying the first processing gas and the second processing gas into the processing container through gas supply pathway separated from each other in the gas discharging member.

30. A gas processing method as claimed in Claim 29, further comprising a purging step of purging the interior of the processing container, between the supply of the first processing gas and the supply of the second processing gas.

31. A gas processing apparatus comprising:

a processing container for housing a substrate to be processed;
a mount table arranged in the processing container to mount the substrate to be processed thereon;
first processing-gas supplying means for supplying a first processing gas into the processing container;
second processing-gas supplying means for supplying a second processing gas into the processing container;
a processing-gas discharging mechanism arranged in a position opposing the substrate to be processed mounted on the mount table to discharge the first processing gas and the second processing gas supplied from the first and second processing-gas supplying means respectively, into the processing container; and exhausting means for exhausting an interior of the processing container, the gas processing apparatus supplying the first processing gas and the second processing gas alternately to react these gases on the substrate to be processed thereby forming a desired film thereon, wherein
the processing-gas discharging mechanism includes a first gas supply pathway and a second gas supply route separated from each other, and the first processing gas and the second processing gas are discharged through the first gas supply pathway and the second gas supply pathway, respectively and individually.

32. A gas processing apparatus as claimed in Claim 31, further comprising purge means for purging the interior of the processing container between the supply of the first processing gas and the supply of the second processing gas.

33. A gas processing apparatus as claimed in Claim 31 or Claim 32, wherein
the processing-gas discharging mechanism includes a gas discharging plate,
a plurality of first gas discharging holes succeeding to the first gas supply pathway are arranged at the central part of the gas discharging plate part, and
a plurality of second gas discharging holes succeeding to the second gas supply route are arranged at the peripheral part of the gas discharging plate.

34. A gas processing apparatus as claimed in Claim 31 or Claim 32, wherein
the processing-gas discharging mechanism includes a gas discharging plate, and
a plurality of first gas discharging holes succeeding to the first gas supply route and a plurality of second gas discharging holes succeeding to the second gas supply pathway are arranged in the gas discharging plate alternately.

35. A gas processing apparatus as claimed in Claim 33 or Claim 34, wherein the processing-gas discharging mechanism has a coolant passage arranged in an area of the gas discharging plate area where the gas discharging holes are formed.

36. A gas processing apparatus as claimed in Claim 35, wherein the coolant passage is formed so as to correspond to the shape of a gas discharging plate's part interposed among the plural gas discharging holes in the gas discharging plate's area where the gas discharging holes are formed.

37. A gas processing apparatus as claimed in Claim 36, wherein the coolant passage is formed concentrically.

38. A gas processing apparatus as claimed in Claim 37, wherein the processing-gas discharging mechanism has a heater.

39. A gas processing apparatus as claimed in Claim 38, further comprising:

a coolant flow piping arranged both in upstream of the coolant passage and in the downstream;
a bypass piping connected, both in upstream of the processing-gas discharging mechanism and in the downstream, to the coolant flow piping while bypassing the processing-gas discharging mechanism;
a pressure relief valve arranged on the downstream side of the coolant passage in the coolant flow piping;
a group of valves defining a flowing pathway of the coolant;
control means for controlling the group of valves; and
a heater for heating the processing-gas discharging mechanism, wherein
when cooling the processing-gas discharging mechanism, the control means controls the group of valves so as to allow the coolant to flow into the coolant passage,

when heating the processing-gas discharging mechanism, the control means operates the heater and further controls the group of valves so as to stop the inflow of the coolant into the coolant passage and allow the coolant to flow into the bypass piping, and

when lowering a temperature of the processing-gas discharging mechanism in its elevated condition in temperature, the control means controls the group of valves so as to allow the coolant to flow into both of the coolant passage and the bypass piping.

FIG. IA

FIG. IB

EP 1 422 317 A1

FIG. 2

EP 1 422 317 A1

F I G. 3

FIG. 4

FIG. 5

FIG. 6

FIG. 7

FIG. 8

47a
47b

47

33

35

# FIG. 9A

47a
47b

47

d
d

33

35

# FIG. 9B

FIG. 10

FIG. 11

FIG. 12

F I G. 13

F I G. 14

EXHAUST
MECHANISM —132

F I G. 15

FIG. 16

FIG. 17

EP 1 422 317 A1

FIG. 18

EP 1 422 317 A1

FIG. 19

EP 1 422 317 A1

FIG. 20

FIG. 21

COOLING WATER

FIG. 22

FIG. 23A

FIG. 23B

233

236

235

234

232

W

231

sub

## FIG. 24

233

237

236

235

234

232

W

231

sub

## FIG. 26

EP 1 422 317 A1

INITIAL W-FILM FORMING PROCESS ST1    MAIN W-FILM FORMING PROCESS ST2

S1  S3  S2  S3  S1  S3  S2  S3  S1  S3  S2  S3  S1    S3

| SiH₄ | WF₆ | SiH₄ | WF₆ | SiH₄ | WF₆ | SiH₄ | WF₆/H₂ |

T1  T3  T2  T3

1 CYCLE

# FIG. 25

COOLING WATER 25°C

FIG. 27

FIG. 28

FIG. 29

FIG. 30

FIG. 31

FIG. 32

FIG. 33A

FIG. 33B

EP 1 422 317 A1

FIG. 34

FIG. 35

# INTERNATIONAL SEARCH REPORT

| | International application No. |
|---|---|
| | PCT/JP02/07856 |

**A. CLASSIFICATION OF SUBJECT MATTER**
Int.Cl$^7$  C23C16/455, H01L21/285

According to International Patent Classification (IPC) or to both national classification and IPC

**B. FIELDS SEARCHED**

Minimum documentation searched (classification system followed by classification symbols)
Int.Cl$^7$  C23C16/455, H01L21/205, 21/285, 21/31–21/32

Documentation searched other than minimum documentation to the extent that such documents are included in the fields searched

| | | | |
|---|---|---|---|
| Jitsuyo Shinan Koho | 1926–1996 | Jitsuyo Shinan Toroku Koho | 1996–2002 |
| Kokai Jitsuyo Shinan Koho | 1971–2002 | Toroku Jitsuyo Shinan Koho | 1994–2002 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2000-212752 A  (Samsung Electronics Co., Ltd.), 02 August, 2000 (02.08.00), | 1,4,12-14, 17,20,29-34 |
| Y | Par. Nos. [0004] to [0005], [0007], [0011] to [0012], [0019] to [0020]; Figs. 3, 4, 6, 7 | 6-11,15,16, 24-27,35-38 |
| A | & KR 200051046 A | 2,3,5,18, 19,28,39 |
| X | JP 11-124677 A  (Tokyo Electron Ltd.), 11 May, 1999 (11.05.99), | 1,4,11-15, 17,20 |
| Y | Par. No. [0019]; Fig. 1 | 6-11,15,16 |
| A | (Family: none) | 2,3,5,18,19 |
| X | JP 9-501272 A  (Philips Electronics N.V.), 04 February, 1997 (04.02.97), | 1,4,11-15, 17,20 |
| Y | Page 9, line 23 to page 10, line 24 | 6-11,15,16 |
| A | & WO 95/33082 A2        & US 5532190 A & EP 742848 A1        & DE 69505234 E | 2,3,5,18,19 |

| ☒ Further documents are listed in the continuation of Box C. | ☐ See patent family annex. |
|---|---|

| | |
|---|---|
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 06 November, 2002 (06.11.02) | 19 November, 2002 (19.11.02) |

| Name and mailing address of the ISA/ | Authorized officer |
|---|---|
| Japanese Patent Office | |
| Facsimile No. | Telephone No. |

Form PCT/ISA/210 (second sheet) (July 1998)

### INTERNATIONAL SEARCH REPORT

| International application No. |
| --- |
| PCT/JP02/07856 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 5-343331 A  (Hitachi, Ltd.),<br>24 December, 1993 (24.12.93),<br>Par. Nos. [0013] to [0020]<br>(Family: none) | 6-9,24-27,<br>35-38 |
| Y | JP 2000-183070 A  (Tokyo Electron Ltd.),<br>30 June, 2000 (30.06.00),<br>Par. No. [0026]<br>(Family: none) | 6-9,24-27,<br>35-38 |
| Y<br><br>A | JP 8-188495 A  (Hitachi, Ltd.),<br>23 July, 1996 (23.07.96),<br>Claims; Par. Nos. [0005], [0010] to [0024]; Figs.<br>1, 2<br>(Family: none) | 10,22,23,27,<br>38<br>21 |
| Y | JP 8-335567 A  (Tokyo Electron Ltd.),<br>17 December, 1996 (17.12.96),<br>Par. No. [0023]; Fig. 1<br>& US 5868848 A          & KR 97003609 A | 16 |
| Y | JP 6-128750 A  (ULVAC Japan Ltd.),<br>10 May, 1994 (10.05.94),<br>Claims; Par. Nos. [0009] to [0012]<br>(Family: none) | 22,23 |
| A | JP 1-87773 A  (Applied Materials, Inc.),<br>31 March, 1989 (31.03.89),<br>Full text<br>& DE 3940203 A          & EP 296891 A2<br>& US 4960488 A | 1-20 |

Form PCT/ISA/210 (continuation of second sheet) (July 1998)

## INTERNATIONAL SEARCH REPORT

International application No.

PCT/JP02/07856

---

**Box I    Observations where certain claims were found unsearchable (Continuation of item 1 of first sheet)**

This international search report has not been established in respect of certain claims under Article 17(2)(a) for the following reasons:

1. ☐ Claims Nos.:

   because they relate to subject matter not required to be searched by this Authority, namely:

2. ☐ Claims Nos.:

   because they relate to parts of the international application that do not comply with the prescribed requirements to such an extent that no meaningful international search can be carried out, specifically:

3. ☐ Claims Nos.:

   because they are dependent claims and are not drafted in accordance with the second and third sentences of Rule 6.4(a).

---

**Box II    Observations where unity of invention is lacking (Continuation of item 3 of first sheet)**

This International Searching Authority found multiple inventions in this international application, as follows:

The "special technical feature" of Claims 1-20  relates to the fact that the treating gas delivery mechanism has a first gas delivery section and a second gas delivery section disposed around the first gas delivery section; the "special technical feature" of Claim 21 relates to the provision of a space layer between a gas delivery section having a heater and a base; the "special technical feature" of Claims 22 and 23 relates to the provision of a fastening mechanism for fastening a gas delivery section having a heater and a base to allow their relative movement; and the "special technical feature" of Claims 24-39 relates to the alternate feeing of a first treating gas and a second
(continued to extra sheet)

1. ☐ As all required additional search fees were timely paid by the applicant, this international search report covers all searchable claims.

2. ☒ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**    ☐    The additional search fees were accompanied by the applicant's protest.

   ☐    No protest accompanied the payment of additional search fees.

---

Form PCT/ISA/210 (continuation of first sheet (1)) (July 1998)

**INTERNATIONAL SEARCH REPORT**

International application No.

PCT/JP02/07856

Continuation of Box No.II of continuation of first sheet(1)

treating gas.  These inventions, which are not in technical relation including one or more identical or corresponding special technical features, are not deemed to be so linked as to form a single general inventive concept.

Form PCT/ISA/210 (extra sheet) (July 1998)